(19) Europäisches Patentamt / European Patent Office / Office européen des brevets

(11) **EP 4 302 967 A1**

(12) **EUROPEAN PATENT APPLICATION**

(43) Date of publication:
**10.01.2024 Bulletin 2024/02**

(21) Application number: **22183675.2**

(22) Date of filing: **07.07.2022**

(51) International Patent Classification (IPC):
**B29C 64/112** (2017.01) **B29C 64/386** (2017.01)
**B29D 11/00** (2006.01) **B33Y 10/00** (2015.01)
**B33Y 50/00** (2015.01)

(52) Cooperative Patent Classification (CPC):
**B29C 64/112; B29C 64/386; B29D 11/00009;
B29D 11/00432; B29D 11/00961; B33Y 10/00;
B33Y 50/00; G02C 7/022;** B29L 2011/0016

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Carl Zeiss Vision International GmbH
73430 Aalen (DE)**

(72) Inventor: **Reese, Martin
73430 Aalen (DE)**

(74) Representative: **Carl Zeiss AG - Patentabteilung
Carl-Zeiss-Straße 22
73447 Oberkochen (DE)**

(54) **METHOD FOR INKJET PRINTING A SPECTACLE LENS**

(57) A computer-implemented method for generating printing instructions for inkjet printing a spectacle lens, said printing instructions being based on a digital twin of said spectacle lens, said digital twin being sliced into a layer stack, the method comprising the steps of:
(i) positioning a volume element in a discrete $x_{m+1}, y_{m+1}, z_{m+1} \ldots x_{n+1}, y_{n+1}, z_{n+1}$ position of a layer of said layer stack, based on a positioning of a volume element in a discrete $x_m, y_m, z_m \ldots x_n, y_n, z_n$ position of an adjacent layer of said layer stack; or
(ii) not positioning a volume element in a discrete $x_{m+1}, y_{m+1}, z_{m+1} \ldots x_{n+1}, y_{n+1}, z_{n+1}$ position of a layer of said layer stack, based on a positioning of a volume element in a discrete $x_m, y_m, z_m \ldots x_n, y_n, z_n$ position of an adjacent layer of said layer stack.

Figure 2

EP 4 302 967 A1

**Description**

The present invention relates to a computer-implemented method for generating printing instructions for inkjet printing a spectacle lens according to the preamble of claim 1 and a method for inkjet printing a spectacle lens according to the preamble of claim 12.

Related prior art

To realize a curved-form lens, according to ISO 13666:2019(E), section 3.6.2, a lens having one surface convex in all meridians and the other surface concave in all meridians, for example, a plurality of layers is inkjet printed in layers, whereby a spatial expansion in x,y direction of said plurality of layers successively increases or decreases in z direction. An increase or decrease of spatial expansion of said plurality of layers is visible as steps in plan view as well as in side view, in particular on a surface of said curved-form lens which has not been in contact with a substrate, said substrate being used as removeable support material for example. An additional processing step, for example polishing to remove said steps or applying a further layer to compensate said steps, usually is required. For example, if, to realize a convex spherical surface of a spectacle lens, the spherical surface as defined in ISO 13666:2019(E), section 3.4.1, the spectacle lens as defined in ISO 13666:2019(E), section 3.5.2, a plurality of circular layers is inkjet printed in layers, a radius determining the circumference of each circular layer of said plurality of circular layers successively decreases from one inkjet printed circular layer to an inkjet printed circular layer on top in z direction. Considering a circular layer of said plurality of circular layers individually, said circular layer may be a continuous circular layer or a non-continuous circular layer. In said continuous circular layer the complete circular area is inkjet printed. In said non-continuous circular layer, an area in between said radius determining the circumference of said circular layer, said radius being the first radius, and a second radius smaller than said first radius is inkjet printed. Further, in said non-continuous circular layer, an area limited by said second radius is not inkjet printed. Again, due to said successively decreasing first radius in said plurality of circular layers stacked in z direction, a front surface and/or back surface of said spectacle lens comprises visible steps in plan view and in side view. These visible steps need to be removed in an additional processing step, for example by polishing the respective surface showing them or by an application of a further layer compensating them. Said respective surface may be a surface which has not been in contact with a substrate used as for example removable support material.

WO 2020/165439 A1 discloses a refractive optical component and a spectacle lens manufactured therefrom. An additive manufacturing method is suggested, the material may be applied droplet by droplet, and the size of the individual droplets and/or the application density may be varied within a single layer.

Problem to be solved

Departing from the above-described disadvantage, obtaining steps on a surface of an inkjet printed spectacle lens, it has been the object of the present invention to provide a possibility avoiding the formation of steps on a surface of a spectacle lens, thus avoiding an additional processing step to remove or to compensate those steps.

Summary of the invention

This problem has been solved by the computer-implemented method according to claim 1 and by the method according to claim 12.

Preferred embodiments, which might be realized in an isolated fashion or in any arbitrary combination, are listed in the dependent claims.

In the computer-implemented method for generating printing instructions for inkjet printing a spectacle lens according to the invention, said printing instructions are based on a digital twin of the spectacle lens, said digital twin being sliced into a layer stack, and the method comprises the steps:

(i) positioning a volume element in a discrete $x_{m+1},y_{m+1},z_{m+1} \ldots x_{n+1},y_{n+1},z_{n+1}$ position of a layer of said layer stack, based on a positioning of a volume element in a discrete $x_m,y_m,z_m \ldots x_n,y_n,z_n$ position of an adjacent layer of said layer stack; or

(ii) not positioning a volume element in a discrete $x_{m+1},y_{m+1},z_{m+1} \ldots x_{n+1},y_{n+1},z_{n+1}$ position of a layer of said layer stack, based on a positioning of a volume element in a discrete $x_m,y_m,z_m \ldots x_n,y_n,z_n$ position of an adjacent layer of said layer stack.

The computer-implemented method is suitable for generating printing instructions for inkjet printing a spectacle lens. The computer-implemented method is suitable for the purpose of generating printing instructions, said printing instructions to be used for inkjet printing a spectacle lens.

"Generating" printing instructions comprises the following steps, preferably in the given order:

a) Slicing a digital twin of a spectacle lens into a layer stack. Preferably, said digital twin is sliced in that an interface of a layer of said layer stack is a linear combination of a surface form of a front surface and a surface form of a back surface of said digital twin. Preferably, for slicing a maximum layer thickness of each layer of said layer stack is preset, said maximum layer thickness preferably being determined by a maximum layer thickness inkjet printable with a single ink droplet. Further preferably, a positioning of adjacent ink droplets in minimum distance to said single ink droplet in a same layer of said layer stack is considered for said determination of said maximum layer thickness. Said positioning of adjacent ink droplets in minimum distance preferably prevents said single ink droplet from a complete spreading. Preferably said minimum distance is preset by a print resolution of an inkjet printer, preferably by a print resolution of an inkjet print head of said ink jet printer. Preferably, for slicing a minimum layer thickness of each layer of said layer stack is preset, said minimum layer thickness preferably being determined by a minimum layer thickness still leading to a continuous layer. Further preferably, a maximum distance of two single ink droplets inkjet printed in a same layer of said layer stack is considered for said determination of said minimum layer thickness. Said maximum distance of said two single ink droplets is a maximum distance that allows for a coalescence of said two single ink droplets. Due to said coalescence a continuous layer is inkjet printable.

Preferably, slicing ensures a knowledge of a layer thickness in each discrete x,y,z position of each layer of said layer stack. A positioning of ink droplets in a minimum distance, preferably according to a print resolution of an inkjet printer, further preferably according to a print resolution of an inkjet print head of an inkjet printer, or a positioning of ink droplets in a maximum distance are tools to support slicing said digital twin of said spectacle lens in a layer stack. Preferably said spectacle lens is inkjet printed with said inkjet printer. Additionally or alternatively, knowledge of a thickness of said digital twin, i.e., a centre thickness, an edge thickness and a thickness in each discrete x,y position in between, support slicing said digital twin of said spectacle lens in a layer stack. Said centre thickness of said digital twin shall mean, analogously to the definition given in ISO 13666:2019(E), section 3.2.47, a thickness of said digital twin of said spectacle lens at its reference point, determined normal to a front surface of said digital twin. Said reference point of said digital twin shall correspond, analogously to the definition given in ISO 13666:2019(E), section 3.2.19, to a point on the front surface of the finished inkjet printed spectacle lens at which the verification power of a specific portion applies. Said edge thickness shall mean, analogously to the definition given in ISO 13666:2019(E), section 3.2.48, a thickness at a point on an edge of said digital twin of said spectacle lens. Said layer thickness in each corresponding x,y,z position of an inkjet printed layer depends on a density of ink droplets in said layer: the more ink droplets are positioned within an area element, the higher a layer thickness in said area element. Said area element preferably is preset to comprise within a layer more than ten discrete positions for ink droplets, i.e., more than ten positions in which an ink droplet (i) is placed or (ii) could be placed but is not placed. Said area element may comprise, preferably when projected in a plane held by a x direction and a y direction, for example, an area of 100 discrete positions for ink droplets, ten in x direction and ten in y direction. Phrased differently, in an inkjet printed layer, a layer thickness is defined as number of ink droplets multiplied by a volume of an ink droplet divided by said area element:

$$layer\ thickness = \frac{number\ of\ ink\ droplets \cdot volume\ of\ ink\ droplet}{area\ element}$$

Preferably, said thickness of said digital twin, i.e., said centre thickness, said edge thickness and said thickness in each discrete x,y position in between, is reflected in a thickness distribution of a layer of said layer stack, preferably in a thickness distribution of each layer apart from a base layer of said layer stack. Reflecting a thickness distribution shall mean that a ratio of said thickness of said digital twin between two discrete x,y positions is identical to a ratio of a layer of said layer stack in two discrete x,y positions having identical z positions as two discrete x,y positions of said digital twin, preferably apart from a base layer.

Preferably, said digital twin is sliced to comprise, according to the before mentioned restriction with respect to a minimum layer thickness or a maximum layer thickness, a maximum number of layers in said layer stack;

b) Converting each layer of said layer stack into a spatial volume element pattern. In said spatial volume element pattern each volume element is positioned in a discrete x,y,z position. In said spatial volume element pattern each volume element represents an ink droplet. In said spatial volume element pattern a volume element serves as a virtual placeholder for an ink droplet. In said spatial volume element pattern each volume element positioned in a discrete x,y,z position serves as a virtual placeholder for each ink droplet to be positioned in a corresponding discrete x,y,z position of a spectacle lens, when said spectacle lens is inkjet printed in layers. Each volume element is a computer-readable representation of a digital positioning of an ink droplet in a discrete x,y,z position in said spatial

EP 4 302 967 A1

volume element pattern of said digital twin of said spectacle lens. Preferably, for converting said digital twin into said spatial volume element pattern a print resolution of an inkjet printer, preferably an inkjet print head of the inkjet printer is considered;

c) Transferring said spatial volume element pattern into printing instructions which, when the printing instructions are executed by an inkjet printer, cause the inkjet printer to print said spectacle lens in layers. Preferably, transferring said sliced spatial volume element pattern into printing instructions which, when the printing instructions are executed by an inkjet printer, cause an inkjet print head of the inkjet printer to release a jet forming an ink droplet in a corresponding discrete x,y,z position in layers. Preferably, said printing instructions are computer-readable data comprising a stack of images, one image for each layer to be inkjet printed, for example tiff images, and a text file, for example in .xml format. Said text file preferably comprises instructions for an order in which said stack of images corresponding to said layer stack is to be inkjet printed. Said text file preferably further comprises process parameters that are required to print said spectacle lens in layers like a power of pinning LEDs to cure the ink droplets, said ink droplets preferably comprising a UV-curable fluid, and an increase of the z-position of an inkjet print head after having inkjet printed a layer to avoid collision of the inkjet print head with said inkjet printed layer.

A discrete x,y,z position of a volume element in a spatial volume element pattern of a digital twin of a spectacle lens is "corresponding" to a discrete x,y,z position of an ink droplet when while inkjet printing said spectacle lens in layers said ink droplet is positioned according to said discrete x,y,z position of said volume element in said spatial volume element pattern of said digital twin of said spectacle lens. Said ink droplet is positioned to that position that is in said spatial volume element patten intended for its discrete positioning. Analogously, a discrete x,y,z position of an ink droplet is "corresponding" to a discrete x,y,z position of a volume element in a spatial volume element pattern of a digital twin of a spectacle lens when while inkjet printing said spectacle lens in layers said ink droplet is positioned in that discrete x,y,z position in which said volume element had served as virtual representation or as virtual placeholder in said spatial volume element pattern of said digital twin.

"Printing instructions" are computer-readable data which, when the printing instructions are executed by an inkjet printer, cause the inkjet printer to inkjet print a spectacle lens.

Printing instructions are computer-readable data based on a sliced digital twin of a spectacle lens. Printing instructions are in the form of computer-readable data and are based on a sliced digital twin of a spectacle lens; when the printing instructions are executed by an inkjet printer, said printing instructions cause the inkjet printer to inkjet print a spectacle lens.

Said printing instructions being computer-readable data or being in the form of computer-readable data preferably are (i) stored on a computer-readable storage medium or (ii) transferred via a data signal. The computer-readable storage medium may be a non-transitory tangible computer-readable storage medium.

Said printing instructions are configured to, when executed by an inkjet printer, to cause the inkjet printer to inkjet print a spectacle lens. Said printing instructions are computer-readable data which, when executed by an inkjet printer, are configured to cause the inkjet printer to inkjet print a spectacle lens in layers, wherein in each layer, beginning from a base layer directly adjacent to an optionally removable substrate, ink droplets are positioned in a discrete x,y,z position. Said discrete x,y,z positions of the ink droplets positioned in layers to inkjet print a spectacle lens correspond to discrete x,y,z positions of volume elements in a spatial volume element pattern of a digital twin of said spectacle lens to be inkjet printed.

Said printing instructions are for the purpose of a use thereof for inkjet printing a spectacle lens. Said printing instructions are computer-readable data for the purpose of a use of said data for inkjet printing a spectacle lens in layers. The inkjet printing of said spectacle lens begins with inkjet printing a base layer directly in or on an optionally removable substrate and continues with inkjet printing layer-by-layer until said spectacle lens is finished inkjet printed. The positioning of each ink droplet in a discrete x,y,z position in each layer is specified by a corresponding discrete x,y,z position of a volume element in a spatial volume element pattern of a digital twin of said spectacle lens to be inkjet printed. Preferably said printing instructions, when the printing instructions are executed by an inkjet printer, cause a print head of the inkjet printer to release a jet forming an ink droplet in a corresponding discrete x,y,z position in layers.

The substrate said base layer is inkjet printed in or on, or said base layer is directly adjacent to, may be removable from the inkjet printed spectacle lens or may remain with the inkjet printed spectacle lens. Preferably, the spectacle lens and the substrate are removable from each other.

Preferably, said printing instructions are in a computer-readable data format comprising a stack of images, one image for each layer to be inkjet printed, for example tiff images, and a text file, for example in .xml format, as described before.

A "spatial volume element pattern" is a digital representation in volume elements or a virtual description in volume elements of each layer of a sliced digital twin of a spectacle lens. Said digital representation or said virtual description are computer-readable data or are in the form of computer-readable data. Said computer-readable data may (i) be stored on a computer-readable storage medium, or (ii) transferred via a data signal. The computer-readable storage

4

medium may be a non-transitory tangible computer-readable storage medium. In a spatial volume element pattern each volume element is spatially positioned in a discrete x,y,z position. In said spatial volume element pattern each volume element in a discrete x,y,z position represents an ink droplet to be positioned in a corresponding discrete x,y,z position when inkjet printing said spectacle lens.

A "digital twin" of a spectacle lens is a mathematical description of a lens surface of a front surface of the spectacle lens, a mathematical description of a lens surface of a back surface of the spectacle lens, said mathematical description optionally including (i) a refractive index for said spectacle lens or (ii) a refractive index distribution $n(x,y,z)$ for said spectacle lens. The lens surface of said digital twin is defined analogously to ISO 13666:2019(E), section 3.4. The refractive index for said spectacle lens is a refractive index said spectacle lens should have after having been inkjet printed. The refractive index distribution is for said spectacle lens is a refractive index distribution said spectacle lens should have after having been inkjet printed.

A digital twin of a spectacle lens is a mathematical description or a mathematical representation of lens surfaces of the spectacle lens, optionally including a refractive index or optionally including a refractive index distribution $n(x,y,z)$, said mathematical description or said mathematical representation being computer-readable data or in the form of computer-readable data. Said computer-readable data may (i) be stored on a computer-readable storage medium, or (ii) transferred via a data signal. The computer-readable storage medium may be a non-transitory tangible computer-readable storage medium. Said computer-readable data may additionally contain printing instructions to inkjet print a spectacle lens. Said computer-readable data may additionally contain printing instructions which, when the printing instructions are executed by an inkjet printer, cause the inkjet printer to inkjet print a spectacle lens.

A digital twin of a spectacle lens may, additionally or alternatively, be one of the following:

- an analytical description or an analytical model describing or representing said spectacle lens. Said analytical description or said analytical model preferably comprises or is (i) a mathematical formula describing a lens surface of a front surface of said digital twin of said spectacle lens and (ii) a mathematical formular describing a lens surface of a back surface of said digital twin of said spectacle lens;
- an analytical description or an analytical model describing or representing said spectacle lens, said analytical description or said analytical model additionally containing printing instructions (i) to inkjet print said spectacle lens or (ii) when executed by an inkjet printer to cause the inkjet printer to inkjet print said spectacle lens;
- in the form of an analytical description or an analytical model representing said spectacle lens;
- in the form of an analytical description or an analytical model representing said spectacle lens, said analytical description or said analytical model additionally containing printing instructions (i) to inkjet print said spectacle lens or (ii) when executed by an inkjet printer to cause the inkjet printer to inkjet print said spectacle lens;
- said analytical description or said analytical model being (i) stored on a computer-readable storage medium or (ii) transferred via a data signal. The computer-readable storage medium may be a non-transitory tangible computer-readable storage medium;
- numerical data describing or representing said spectacle lens. Said numerical data preferably are comprising or being a conversion of said analytical description or said analytical model. Said numerical data preferably are comprising a pattern which comprises discrete x,y positions of or on a front surface of said digital twin of said spectacle lens and discrete x,y positions of or on a back surface of said digital twin of said spectacle lens. Said discrete x,y positions preferably are considering a print resolution of an inkjet printer, preferably a print resolution of an inkjet print head of an inkjet printer. Preferably, in each of said discrete x,y positions a lens surface is described by a mathematical formula. So, said numerical data comprises an analytical description or an analytical model of said lens surface in each of said discrete x,y positions. Optionally, a refractive index or a refractive index distribution, said refractive index distribution comprising a pattern which comprises (i) discrete x,y positions of or on a front surface of said digital twin of said spectacle lens ($n(x,y)$), (ii) discrete x,y positions of or on a back surface of said digital twin of said spectacle lens ($n(x,y)$) and (iii) discrete x,y,z positions in between said front surface and said back surface ($n(x,y,z)$), is comprised in said numerical data. Preferably, said numerical data are taken as a basis for slicing. Compared to taking said analytical description or said analytical model as a basis for slicing, less computing power is needed when said numerical data are taken as a basis for slicing. Phrased differently, slicing said numerical data is computationally less expensive;
- numerical data describing or representing said spectacle lens, said numerical data additionally containing printing instructions (i) to inkjet print said spectacle lens or (ii) when executed by an inkjet printer to cause the inkjet printer to inkjet print said spectacle lens;
- in the form of numerical data describing or representing said spectacle lens;
- in the form of numerical data describing or representing said spectacle lens, said numerical data additionally containing printing instructions (i) to inkjet print said spectacle lens or (ii) when executed by an inkjet printer to cause the inkjet printer to inkjet print said spectacle lens;
- said numerical data being (i) stored on a computer-readable storage medium or (ii) transferred via a data signal.

The computer-readable storage medium may be a non-transitory tangible computer-readable storage medium;

- computer-readable data describing or representing said spectacle lens;
- computer-readable data describing or representing said spectacle lens, said computer-readable data additionally containing printing instructions (i) to inkjet print said spectacle lens or (ii) when executed by an inkjet printer to cause the inkjet printer to inkjet print said spectacle lens;
- in the form of computer-readable data describing or representing said spectacle lens;
- in the form of computer-readable data describing or representing said spectacle lens, said computer-readable data additionally containing printing instructions (i) to inkjet print said spectacle lens or (ii) when executed by an inkjet printer to cause the inkjet printer to inkjet print said spectacle lens;
- said computer-readable data being (i) stored on a computer-readable storage medium or (ii) transferred via a data signal. The computer-readable storage medium may be a non-transitory tangible computer-readable storage medium.

A "spectacle lens" or lens is as defined in ISO 13666:2019(E), section 3.5.2, an ophthalmic lens worn in front of, but not in contact with, the eyeball.

A front surface is as defined in ISO 13666:2019(E), section 3.2.13, a surface of a lens intended to be fitted away from the eye. A back surface is as defined in ISO 13666:2019(E), section 3.2.14, a surface of a lens (3.5.2) intended to be fitted nearer to the eye.

In the context of the present invention, a spectacle lens is further a physical representation of a corresponding digital twin of said spectacle lens, said spectacle lens being an inkjet printed physical representation of said corresponding digital twin.

"Slicing" is a conversion of a digital twin of a spectacle lens into a layer stack. Preferably, slicing is a conversion of said digital twin digitally represented by numerical data, the numerical data as defined before, into a layer stack. Slicing is a digital conversion of said digital twin into a layer stack in which for each layer a layer thickness is preset. Said layer thickness is preset digitally in a centre, in an edge and in between in each x,y,z position of said layer. Preferably, each layer of said layer stack has an identical spatial expansion, in plan view, when projected in a plane held by a x direction and a y direction.

"Positioning" is a digital placement or virtual arrangement or digital distribution of a volume element in a discrete x,y,z position of each layer of a layer stack of a sliced digital twin of a spectacle lens . The positioning of a volume element in a discrete x,y,z position preferably includes (i) a digital placement or virtual arrangement within a layer as well as (ii) a digital placement or virtual arrangement in an adjacent layer, in a next but one layer, in an adjacent layer to a next but one layer, and so on.

Said positioning of a volume element in a discrete $x_{+1},y_{+1},z_{+1}$ position of a layer depends on or is based on a positioning of a volume element in an adjacent layer in a discrete x,y,z position. In said adjacent layer each volume element is positioned in a discrete x,y,z position. In said adjacent layer, preferably when projected in a plane held by a x direction and a y direction, in plan view, each volume element has a discrete x,y,z position. In said layer, preferably when projected in a plane held by a x direction and a y direction, in plan view, each volume element has a discrete $x_{+1},y_{+1},z_{+1}$ position, when positioned directly adjacent and on top of a volume element having a discrete x,y,z position in said adjacent layer. Said layer and said adjacent layer are stacked in z direction. The z direction is perpendicular to said plane held by the x direction and the y direction.

When positioning volume elements in layers, volume elements of a first adjacent layer on whose volume element positioning a further digital placement of volume elements depend on are digitally placed. After their digital placement those volume elements form then the basis of a second adjacent layer on whose volume element positioning a further digital placement of further volume elements depends on. Those digitally placed volume elements in turn form the basis of a third adjacent layer on whose volume element positioning a further digital placement of further volume elements depend on. Said positioning in layers is repeated until volume elements in a final layer are digitally placed dependent on a volume element positioning of a then adjacent layer underneath.

Not positioning a volume element in a discrete $x_{+1},y_{+1},z_{+1}$ position of a layer depends on or is based on a positioning of a volume element in an adjacent layer in a discrete x,y,z position. In said adjacent layer each volume element is (i) positioned in a discrete x,y,z position or (ii) not positioned in a discrete x,y,z position. With respect to said not positioning before given explanation for positioning apply.

A digital twin of a spectacle lens is sliced in a layer stack. Said layer stack comprises a plurality of layers. Preferably said layer stack comprises up to 200 layers stacked, further preferably up to 150 layers stacked. Further preferably said layer stack comprises between 50 and 130 layers stacked, further preferably between 60 and 120 layers stacked, more preferably between 70 and 110 layers stacked and most preferably between 80 and 120 layers stacked. Preferably for slicing said digital twin of said spectacle lens the print resolution of an inkjet printer, preferably an inkjet print head of said inkjet printer, which is to be used for inkjet printing said spectacle lens is considered.

In said layer stack a volume element is

(i) positioned, i.e., digitally placed or virtually arranged or digitally distributed in a discrete $x_{m+1}, y_{m+1}, z_{m+1} \ldots x_{n+1}, y_{n+1}, z_{n+1}$ position of a layer dependent on a positioning of a volume element in an adjacent layer in a discrete $x_m, y_m, z_m \ldots x_n, y_n, z_n$ position, or

(ii) not positioned, i.e., not digitally placed or not virtually arranged or not digitally distributed, in a discrete $x_{m+1}, y_{m+1}, z_{m+1} \ldots x_{n+1}, y_{n+1}, z_{n+1}$ position of a layer dependent on a positioning of a volume element in an adjacent layer in a discrete $x_m, y_m, z_m \ldots x_n, y_n, z_n$ position.

A volume element has a discrete $x_{m+1}, y_{m+1}, z_{m+1} \ldots x_{n+1}, y_{n+1}, z_{n+1}$ position in a layer preferably in plan view when said layer is projected in a plane held by a x direction and a y direction. A volume element having a discrete $x_{m+1}, y_{m+1}, z_{m+1} \ldots x_{n+1}, y_{n+1}, z_{n+1}$ position in a layer is directly adjacent and on top of a volume element having a discrete $x_m, y_m, z_m \ldots x_n, y_n, z_n$ position in an adjacent layer, preferably said adjacent layer also in plan view when projected in a plane held by a x direction and a y direction, if the two volume elements differ only in their z position. In said layer stack, preferably in plan view with all layers projected in a plane held by a x direction and a y direction, volume elements are digitally placed on top of each other when having an identical x,y position but having a different z position. Digitally placed on top of each other means in a layer, $z_{m+1}$, a next but one layer, $z_{m+2}$, a layer adjacent to a next but one layer, $z_{m+3}$, and so on. Digitally placed on top of each other does not mean that in each of a layer, $z_{m+1}$, a next but one layer, $z_{m+2}$, a layer adjacent to a next but one layer, $z_{m+3}$, and so on, a volume element is digitally placed, a volume element could be digitally placed on top of each other in any layer of said layer stack in a $z_m$ position but need not to be placed in each layer in a $z_m$ position. In case a volume element is not digitally placed in a layer, $z_{m+1}$, but in a next but one layer, $z_{m+2}$, or in a layer adjacent to a next but one layer, $z_{m+3}$, and so on, said volume element and a volume element digitally placed in a $z_m$ position are, when having an identical x,y position, on top of each other but not adjacent to each other.

In said layer stack said positioning of volume elements begins with a digital placement of volume elements in a base layer. Said base layer preferably is a digital representation of a layer directly adjacent to a substrate. Said base layer preferably is a digital representation of a layer which is inkjet printed in or on a substrate. In said base layer, preferably in plan view when projected in a plane held by a x direction and a y direction, in each discrete x,y,z position of said base layer a volume element is digitally placed. Said base layer, preferably in plan view when projected in a plane held by a x direction and a y direction, is having a constant thickness. In said layer stack said positioning of volume elements ends with a digital placement of volume elements in a final layer. In an inkjet printed spectacle lens said base layer is either a front surface or a back surface of said spectacle lens, said final layer then is accordingly a back surface or a front surface thereof. In between said base layer and said final layer a

(i) positioning of volume elements in a discrete $x_{m+1}, y_{m+1}, z_{m+1} \ldots x_{n+1}, y_{n+1}, z_{n+1}$ position of a layer, or

(ii) not positioning of volume elements in a discrete $x_{m+1}, y_{m+1}, z_{m+1} \ldots x_{n+1}, y_{n+1}, z_{n+1}$ position of a layer, each depends on or is based on a positioning of a volume element in an adjacent layer in a discrete Xm,ym,Zm ... Xn,yn,Zn position.

In said layer stack said

(i) positioning of volume elements in a discrete $x_{m+1}, y_{m+1}, z_{m+1} \ldots x_{n+1}, y_{n+1}, z_{n+1}$ position of a layer or first layer adjacent to said base layer, preferably in plan view when projected in a plane held by a x direction and a y direction, or

(ii) not positioning of volume elements in a discrete $x_{m+1}, y_{m+1}, z_{m+1} \ldots x_{n+1}, y_{n+1}, z_{n+1}$ position of a layer or first layer adjacent to said base layer, preferably in plan view when projected in a plane held by a x direction and a y direction,

each depends on or is based on a positioning of a volume element in said adjacent base layer in a discrete $x_m, y_m, z_m \ldots x_n, y_n, z_n$ position.

In said layer stack said

(i) positioning of volume elements in a discrete $x_{m+2}, y_{m+2}, z_{m+2} \ldots x_{n+2}, y_{n+2}, z_{n+2}$ position of a next but one layer or second layer, preferably in plan view when projected in a plane held by a x direction and a y direction, or

(ii) not positioning of volume elements in a discrete $x_{m+2}, y_{m+2}, z_{m+2} \ldots x_{n+2}, y_{n+2}, z_{n+2}$ position of a next but one layer or second layer, preferably in plan view when projected in a plane held by a x direction and a y direction,

each depends on or is based on a positioning of a volume element in said layer or first layer in a discrete $x_{m+1}, y_{m+1}, z_{m+1} \ldots x_{n+1}, y_{n+1}, z_{n+1}$ position. Said next but one layer or second layer is adjacent to said layer or first layer and next but one to said base layer.

In said layer stack said

(i) positioning of volume elements in a discrete $x_{m+3}, y_{m+3}, z_{m+3} \ldots x_{n+3}, y_{n+3}, z_{n+3}$ position of a layer adjacent to a next but one layer or third layer, preferably in plan view when projected in a plane held by a x direction and a y direction, or

(ii) not positioning of volume elements in a discrete $x_{m+3},y_{m+3},z_{m+3} \cdots x_{n+3},y_{n+3},z_{n+3}$ position of a layer adjacent to a next but one layer or third layer, preferably in plan view when projected in a plane held by a x direction and a y direction,

each depends on or is based on a positioning of a volume element in said next but one layer or second layer in a discrete $x_{m+2},y_{m+2},z_{m+2} \cdots x_{n+2},y_{n+2},z_{n+2}$ position. Said layer adjacent to a next but one layer or third layer is a layer adjacent to said next but one layer or second layer, a next but one layer to said layer or first layer and adjacent to the next but one layer of said base layer.

In said layer stack said (i) positioning of volume elements or (ii) not positioning of volume elements in a discrete $x_{m+u},y_{m+u},z_{m+u} \cdots x_{n+v},y_{n+v},z_{n+v}$ position is repeated until volume elements in said final layer are (i) positioned or (ii) not positioned.

Said (i) positioning of a volume element in a discrete $x_{m+1},y_{m+1},z_{m+1} \cdots x_{n+1},y_{n+1},z_{n+1}$ position or said (ii) not positioning of a volume element in a discrete $x_{m+1},y_{m+1},z_{m+1} \cdots x_{n+1},y_{n+1},z_{n+1}$ position, each dependent on or being based on a positioning of a volume element in an adjacent layer in a discrete $x_m,y_m,z_m \cdots x_n,y_n,z_n$ position results in a variation of a volume element density. Preferably, said variation of the volume element density is given in each layer of said layer stack apart from the base layer. Said variation of the volume element density in a layer of said layer stack of said sliced digital twin is a digital representation of a variation of ink droplets in a layer. Printing instructions comprising said variation of the volume element density executed by an inkjet printer, cause an inkjet printer, preferably a printhead of the inkjet printer, to release a jet forming an ink droplet according to said variation in layers. A variation of ink droplets in a layer results in a variation of a layer thickness of said layer. A variation of said layer thickness avoids issues with respect to waviness in an inkjet printed spectacle lens. In contrast to WO 2020/165439 A1 disclosing on page 25, lines 10 to 18, or on page 26, lines 23 to 30, to vary a droplet density within a single layer, the present invention not only suggests varying a density of ink droplets in a layer but to vary a volume element density, digitally representing a density of ink droplets, in a layer based on a positioning of a volume element in an adjacent layer. This has as decisive advantage of avoiding steps on a surface of an inkjet printed spectacle lens, both in plan view and in side view. Also, residual structures that can impact the optical quality of the spectacle lens are minimized in each layer.

"Positioning a volume element" shall include a positioning of one volume element in a discrete x,y,z position or a positioning of more volume elements in a discrete x,y,z position.

"Not positioning a volume element" shall mean that in a discrete x,y,z position no volume element is positioned.

"Discrete" shall mean an integer multiple of a minimum nozzle distance of an inkjet print head or an arrangement of two or more inkjet print heads.

"A inkjet print head "shall mean a single inkjet print head or an arrangement of two or more inkjet print heads.

"Layer thickness" is, preferably of a sliced digital twin of a spectacle lens projected in a plane held by a x direction and a y direction, in side view, in z direction, a shortest distance between a point

- on an outermost surface of a layer to a point perpendicular to said point in z direction on the nearest interface of said layer, or
- on an interface of a layer to another layer to a point perpendicular to said point in z direction on the nearest interface of said layer.

The above-described problem is fully solved by a computer-implemented method described in the forgoing. A targeted positioning of a volume element in a layer dependent on or based on being based on a positioning of a volume element in an adjacent layer results in a variation of a volume element density in said layer. Said variation in volume element density results in a variation of a layer thickness when an ink jet printer, preferably a print head of the inkjet printer, releases a jet forming an ink droplet in a corresponding position to said targeted positioned volume element. Thus, in turn avoids to a formation of steps in an inkjet printed spectacle lens.

In a preferred embodiment of the invention, the computer-implemented method is characterized by one of the following conditions:

- when in less than 50% of said discrete $x_m,y_m,z_m \cdots x_n,y_n,z_n$ positions a volume element is positioned then no volume element is positioned in each of said discrete $x_{m+1},y_{m+1},z_{m+1} \cdots x_{n+1},y_{n+1},z_{n+1}$ positions;
- when in 50% or more than 50% of said discrete $x_m,y_m,z_m \cdots x_n,y_n,z_n$ positions a volume element is positioned then volume elements are positioned partially in said discrete $x_{m+1},y_{m+1},z_{m+1} \cdots x_{n+1},y_{n+1},z_{n+1}$ positions.

Not to position a volume element in a discrete $x_{m+1},y_{m+1},z_{m+1} \cdots x_{n+1},y_{n+1+},z_{n+1}$ position when in less than 50% of discrete $x_m,y_m,z_m \cdots x_n,y_n,z_n$ positions of an adjacent layer a volume element is already positioned means that in two adjacent layers volume elements are not directly adjacent and not on top of each other positioned. Instead a volume element is positioned in a discrete $x_{m+1a},y_{m+1a},z_{m+1a} \cdots x_{n+1a},y_{n+1a},z_{n+1a}$ position which is not on top of a volume element positioned in a discrete $x_m,y_m,z_m$ ... $x_n,y_n,z_n$ position of an adjacent layer.

To position a volume element in a discrete $x_{m+1},y_{m+1},z_{m+1}$ ... $x_{n+1},y_{n+1},z_{n+1}$ position or not to position a volume element in a discrete $x_{m+1},y_{m+1},z_{m+1}$ ... $x_{n+1},y_{n+1},z_{n+1}$ position when in 50% or more than 50% of discrete $x_m,y_m,z_m$ ... $x_n,y_n,z_n$ positions of an adjacent layer a volume element is already positioned means that preferably in a first step a volume element is not positioned in a discrete $x_{m+1},y_{m+1},z_{m+1}$ ... $x_{n+1},y_{n+1},z_{n+1}$ position when in a discrete $x_m,y_m,z_m$ ... $x_n,y_n,z_n$ position of an adjacent layer a volume element is already positioned. Instead a volume element is positioned in a discrete $x_{m+1a},y_{m+1a},z_{m+1a}$ ... $x_{n+1a},y_{n+1a},z_{n+1a}$ position which is not on top of a volume element positioned in a discrete $x_m,y_m,z_m$ ... $x_n,y_n,z_n$ position of said adjacent layer. When volume elements are positioned in all $x_{m+1a},y_{m+1a},z_{m+1a}$ ... $x_{n+1a},y_{n+1a},z_{n+1a}$ positions then in a second step a volume element is positioned in a discrete $x_{m+1},y_{m+1},z_{m+1}$ ... $x_{n+1},y_{n+1+},z_{n+1}$ position. Preferably, when positioning a volume element in a discrete $X_{m+1a},y_{m+1a},z_{m+1a}$ ... $x_{n+1a},y_{n+1a},z_{n+1a}$ position a maximum distance between two volume elements is considered. Said maximum distance preferably corresponds to a maximum distance of two single ink droplets allowing for a coalescence of said two single ink droplets in an inkjet printed layer and thus ensuring a continuous inkjet printed layer. Preferably, when positioning a volume element (i) in a discrete $Xm+1,ym+1,Zm+1$ ... $x_{n+1},y_{n+1+},z_{n+1}$ position or (ii) in a discrete $x_{m+1a},y_{m+1a},z_{m+1a}$ ... $Xn+1a,yn+1a,Zn+1a$ position a variation in a distance between two adjacent volume elements in said layer is minimized. Inkjet printing a spectacle lens in layers considering said minimized variation in a distance between two adjacent ink droplets in a layer, preferably enables a smoothest possible surface or interface of said layer. Preferably, adjacent volume elements are positioned to result in a variation of a distance between adjacent volume element of less than 50%, preferably less than 25%.

In a preferred embodiment of the invention, the computer-implemented method is characterized by one of the following conditions:

- when in less than 50% of said discrete $x_m,y_m,z_m$ ... $x_n,y_n,z_n$ positions a volume element is positioned then no volume element is positioned in each of said discrete $x_{m+1},y_{m+1},z_{m+1}$ ... $x_{n+1},y_{n+1},z_{n+1}$ positions and volume elements are positioned in each of a discrete $x_{m+2},y_{m+2},z_{m+2}$ ... $x_{n+2},y_{n+2},z_{n+2}$ positions of a next but one layer of said layer stack;
- when in 50% or more than 50% of said discrete $x_m,y_m,z_m$ ... $x_n,y_n,z_n$ positions a volume element is positioned then volume elements are positioned partially in said discrete $x_{m+1},y_{m+1},z_{m+1}$ ... $x_{n+1},y_{n+1},z_{n+1}$ positions and volume elements are positioned partially in discrete $x_{m+2},y_{m+2},z_{m+2}$ ... $x_{n+2},y_{n+2},z_{n+2}$ positions of a next but one layer of said layer stack.

Not to position a volume element in a discrete $x_{m+1},y_{m+1},z_{m+1}$ ... $x_{n+1},y_{n+1+},z_{n+1}$ position of a layer when in less than 50% of discrete $x_m,y_m,z_m$ ... $x_n,y_n,z_n$ positions of an adjacent layer a volume element is already positioned but to position a volume element in a discrete $x_{m+2},y_{m+2},z_{m+2}$ ... $x_{n+2},y_{n+2},z_{n+2}$ position when in less than 50% of discrete $x_m,y_m,z_m$ ... $x_n,y_n,z_n$ positions of said adjacent layer a volume element is already positioned means that a volume element of said next but one layer is positioned on top of a volume element of said adjacent layer but that these two volume elements are not adjacent to each other. In said layer in between said adjacent layer and said next but one layer a volume element is positioned in a discrete $x_{m+1a},y_{m+1a},z_{m+1a}$ ... $x_{n+1a},y_{n+1a},z_{n+1a}$ position which is not on top of a volume element positioned in a discrete $x_m,y_m,z_m$ ... $x_n,y_n,z_n$ position of said adjacent layer. Preferably, as mentioned before, when positioning a volume in a discrete $x_{m+1a},y_{m+1a},z_{m+1a}$ ... $x_{n+1a},y_{n+1a},z_{n+1a}$ position a maximum distance between two volume elements is considered. Preferably, as explained before, in said layer a variation in a distance between two adjacent volume elements is minimized.

To position a volume element in a discrete $x_{m+1},y_{m+1},z_{m+1}$ ... $x_{n+1},y_{n+1},z_{n+1}$ position or not to position a volume element in a discrete $x_{m+1},y_{m+1},z_{m+1}$ ... $x_{n+1},y_{n+1},z_{n+1}$ position of a layer when in 50% or more than 50% of discrete $x_m,y_m,z_m$ ... $x_n,y_n,z_n$ positions of an adjacent layer a volume element is already positioned and to position a volume element in a discrete $x_{m+2},y_{m+2},z_{m+2}$ ... $x_{n+2},y_{n+2},z_{n+2}$ position or not to position a volume element in a discrete $x_{m+2},y_{m+2},z_{m+2}$ ... $x_{n+2},y_{n+2},z_{n+2}$ position of a next but one layer to said adjacent layer when in 50% or more than 50% of discrete $x_m,y_m,z_m$ ... $x_n,y_n,z_n$ positions of said adjacent layer a volume element is already positioned means that preferably in a first step a volume element is not positioned in a discrete $x_{m+1},y_{m+1},z_{m+1}$ ... $x_{n+1},y_{n+1},z_{n+1}$ position of said layer when in a discrete $x_m,y_m,z_m$ ... $x_n,y_n,z_n$ position of said adjacent layer a volume element is already positioned and a volume element is not positioned in a discrete $x_{m+2},y_{m+2},z_{m+2}$ ... $x_{n+2},y_{n+2},z_{n+2}$ position of said next but one layer when in a discrete $x_m,y_m,z_m$ ... $x_n,y_n,z_n$ position of said adjacent layer a volume element is already positioned. Instead a volume element is positioned in a discrete $X_{m+1a},y_{m+1a},z_{m+1a}$ ... $x_{n+1a},y_{n+1a},z_{n+1a}$ position which is not adjacent and not on top of a volume element positioned in a discrete $x_m,y_m,z_m$ ... $x_n,y_n,z_n$ position of said adjacent layer and instead a volume element is positioned in a discrete $x_{m+2b},y_{m+2}b,z_{m+2b}$ ... $x_{n+2b},y_{n+2b},z_{n+2b}$ position of said next but one layer which is not adjacent to and not on top of a volume element positioned in a discrete $x_{m+1a},y_{m+1a},z_{m+1a}$ ... $x_{n+1a},y_{n+1a},z_{n+1a}$ position of said layer and which is not on top of a volume element positioned in a discrete $x_m,y_m,z_m$ ... $x_n,y_n,z_n$ position of said adjacent layer. When volume elements are positioned in all $x_{m+1a},y_{m+1a},z_{m+1a}$ ... $x_{n+1a},y_{n+1a},z_{n+1a}$ positions and in all discrete $x_{m+2b},y_{m+2}b,z_{m+2b}$ ... $x_{n+2b},y_{n+2b},z_{n+2b}$ positions then in a second step a volume element is positioned in a

discrete $x_{m+1},y_{m+1},z_{m+1} \dots x_{n+1},y_{n+1+},z_{n+1}$ position and in a discrete $x_{m+2},y_{m+2},z_{m+2} \dots x_{n+2},y_{n+2},z_{n+2}$ position. Preferably, when positioning a volume in a discrete $x_{m+1a},y_{m+1a},z_{m+1a} \dots x_{n+1a},y_{n+1a},z_{n+1a}$ position or in a discrete $x_{m+2b},y_{m+2}b,z_{m+2b} \dots x_{n+2b},y_{n+2b},z_{n+2b}$ position in each of said layer and said next but one layer a maximum distance between two volume elements is considered. Said maximum distance preferably corresponds to a maximum distance of two single ink droplets allowing for a coalescence of said two single ink droplets in an inkjet printed layer and thus ensuring a continuous inkjet printed layer. Preferably, when positioning a volume element (i) in a discrete $x_{m+1},y_{m+1},z_{m+1} \dots x_{n+1},y_{n+1+},z_{n+1}$ position, (ii) in a discrete $x_{m+1a},y_{m+1a},z_{m+1a} \dots x_{n+1a},y_{n+1a},z_{n+1a}$ position, or (iii) in a discrete $x_{m+2b},y_{m+2}b,z_{m+2b} \dots x_{n+2b},y_{n+2b},z_{n+2b}$ position a variation in a distance between two adjacent volume elements in said layer or said next but one layer is minimized. Inkjet printing a spectacle lens in layers considering said minimized variation in a distance between two adjacent ink droplets in a layer, preferably enables a smoothest possible surface or interface of said layer or said next but one layer.

In a preferred embodiment of the invention, the computer-implemented method is characterized by the following condition:

- when in 50% or more than 50% of said discrete $x_{m+2},y_{m+2},z_{m+2} \dots x_{n+2},y_{n+2},z_{n+2}$ positions and in 66% or less than 66% of said discrete $x_{m+2},y_{m+2},z_{m+2} \dots x_{n+2},y_{n+2},z_{n+2}$ positions of said next but one layer a volume element is to be positioned then said volume element is positioned in

  ○ a discrete $x_{m+2b},y_{m+2}b,z_{m+2b} \dots x_{n+2b},y_{n+2b},z_{n+2b}$ position not adjacent and not on top of a volume element in a discrete $x_{m+1},y_{m+1},z_{m+1} \dots x_{n+1},y_{n+1},z_{n+1}$ position of said layer and not on top of a volume element in a discrete $x_m,y_m,z_m \dots x_n,y_n,z_n$, position of said adjacent layer, or
  ○ a discrete $x_{m+2a},y_{m+2a},z_{m+2a} \dots x_{n+2a},y_{n+2a},z_{n+2a}$ position adjacent and on top of a volume element in a discrete $x_{m+1a},y_{m+1a},z_{m+1a} \dots x_{n+1a},y_{n+1a},z_{n+1a}$ position of said layer and not on top of a volume element in a discrete $x_m,y_m,z_m \dots x_n,y_n,z_n$ position of said adjacent layer, or
  ○ a discrete $x_{m+2b},y_{m+2}b,z_{m+2b} \dots x_{n+2b},y_{n+2b},z_{n+2b}$ position not adjacent and not on top of a volume element in a discrete $x_{m+1},y_{m+1},z_{m+1} \dots x_{n+1},y_{n+1},z_{n+1}$ position of said layer and on top of a volume element in an discrete $x_m,y_m,z_m \dots x_n,y_n,z_n$ position of said adjacent layer, or
  ○ a discrete $x_{m+2a},y_{m+2a},z_{m+2a} \dots x_{n+2a},y_{n+2a},z_{n+2a}$ position adjacent and on top of a volume element in a discrete $x_{m+1a},y_{m+1a},z_{m+1a} \dots x_{n+1a},y_{n+1a},z_{n+1a}$ position of said layer and on top of a volume element in an discrete $x_m,y_m,z_m \dots x_n,y_n,z_n$ position of said adjacent layer.

Preferably, this condition considers a positioning of volume elements in said next but one layer. Preferably, for positioning a volume element in said layer one of the above-described conditions shall apply.

Preferably, as explained before, when positioning a volume in a discrete $x_{m+1a},y_{m+1a},z_{m+1a} \dots x_{n+1a},y_{n+1a},z_{n+1a}$ position or in a discrete $x_{m+2b},y_{m+2}b,z_{m+2b} \dots x_{n+2b},y_{n+2b},z_{n+2b}$ position in each of said layer and said next but one layer a maximum distance between two volume elements is considered. Preferably, as explained before, in each of the before mentioned layers a variation in a distance between two adjacent volume elements is minimized.

Preferably, when in 50% or more than 50% of said discrete $x_{m+2},y_{m+2},z_{m+2} \dots x_{n+2},y_{n+2},z_{n+2}$ positions and in 66% or less than 66% of said discrete $x_{m+2},y_{m+2},z_{m+2} \dots x_{n+2},y_{n+2},z_{n+2}$ positions of said next but one layer a volume element is to be positioned then said volume element is positioned in a discrete $Xm+2b,ym+2b,Zm+2b \dots Xn+2b,yn+2b,Zn+2b$ position not adjacent and not on top of a volume element in a discrete $x_{m+1},y_{m+1},z_{m+1} \dots x_{n+1},y_{n+1},z_{n+1}$ position of said layer and not on top of a volume element in a discrete $x_m,y_m,z_m \dots x_n,y_n,z_n$, position of said adjacent layer.

In case in 50% or more than 50% of said discrete $x_{m+2},y_{m+2},z_{m+2} \dots x_{n+2},y_{n+2},z_{n+2}$ positions and in 66% or less than 66% of said discrete $x_{m+2},y_{m+2},z_{m+2} \dots x_{n+2},y_{n+2},z_{n+2}$ positions of said next but one layer a volume element is to be positioned and either

  (i) in one of said layer or said adjacent layer a volume element is already positioned in a discrete $x_{m+1},y_{m+1},z_{m+1} \dots x_{n+1},y_{n+1},z_{n+1}$ position or in a discrete $Xm,ym,Zm \dots x_n,y_n,z_n$, position, or
  (ii) in both of said layer or said adjacent layer a volume element is already positioned in a discrete $x_{m+1},y_{m+1},z_{m+1} \dots x_{n+1},y_{n+1},z_{n+1}$ position and in a discrete $x_m,y_m,z_m \dots x_n,y_n,z_n$, position,

preferably the respective before mentioned positioning shall apply.

In a preferred embodiment of the invention, the computer-implemented method is characterized by the following condition:

- when in more than 66% of discrete $x_{m+3},y_{m+3},z_{m+3} \dots x_{n+3},y_{n+3},z_{n+3}$ positions and in 75% or less than 75% of said discrete $x_{m+3},y_{m+3},z_{m+3} \dots x_{n+3},y_{n+3},z_{n+3}$ positions of an adjacent layer to said next but one layer a volume element is to be positioned then said volume element is positioned in

○ a discrete $x_{m+3b},y_{m+3b},z_{m+3b} \ldots x_{n+3b},y_{n+3b},z_{n+3b}$ position not adjacent and not on top of a volume element in a discrete $x_{m+2},y_{m+2},z_{m+2} \ldots x_{n+2},y_{n+2},z_{n+2}$ position of said next but one layer and not on top of a volume element in a discrete $x_{m+1},y_{m+1},z_{m+1} \ldots x_{n+1},y_{n+1},z_{n+1}$ position of said layer and not on top of a volume element in a discrete $x_m,y_m,z_m \ldots x_n,y_n,z_n$, position of said adjacent layer, or

○ a discrete $x_{m+3b},y_{m+3b},z_{m+3b} \ldots x_{n+3b},y_{n+3b},z_{n+3b}$ position not adjacent and not on top of a volume element in a discrete $x_{m+2},y_{m+2},z_{m+2} \ldots x_{n+2},y_{n+2},z_{n+2}$ position of said next but one layer and not on top of a volume element in a discrete $x_{m+1},y_{m+1},z_{m+1} \ldots x_{n+1},y_{n+1},z_{n+1}$ position of said layer and on top of a volume element in a discrete $x_m,y_m,z_m \ldots x_n,y_n,z_n$, position of said adjacent layer, or

○ a discrete $x_{m+3b},y_{m+3b},z_{m+3b} \ldots x_{n+3b},y_{n+3b},z_{n+3b}$ position not adjacent and not on top of a volume element in a discrete $x_{m+2},y_{m+2},z_{m+2} \ldots x_{n+2},y_{n+2},z_{n+2}$ position of said next but one layer and on top of a volume element in a discrete $x_{m+1b},y_{m+1b},z_{m+1b} \ldots x_{n+1b},y_{n+1b},z_{n+1b}$ position of said layer and not on top of a volume element in a discrete $x_m,y_m,z_m \ldots x_n,y_n,z_n$, position of said adjacent layer, or

○ a discrete $x_{m+3a},y_{m+3a},z_{m+3a} \ldots x_{n+3a},y_{n+3a},z_{n+3a}$ position adjacent and on top of a volume element in a discrete $x_{m+2a},y_{m+2a},z_{m+2a} \ldots x_{n+2a},y_{n+2a},z_{n+2a}$ position of said next but one layer and not on top of a volume element in a discrete $x_{m+1},y_{m+1},z_{m+1} \ldots x_{n+1},y_{n+1},z_{n+1}$ position of said layer and not on top of a volume element in a discrete $x_m,y_m,z_m \ldots x_n,y_n,z_n$, position of said adjacent layer, or

○ a discrete $x_{m+3a},y_{m+3a},z_{m+3a} \ldots x_{n+3a},y_{n+3a},z_{n+3a}$ position adjacent and on top of a volume element in a discrete $x_{m+2a},y_{m+2a},z_{m+2a} \ldots x_{n+2a},y_{n+2a},z_{n+2a}$ position of said next but one layer and not on top of a volume element in a discrete $x_{m+1},y_{m+1},z_{m+1} \ldots x_{n+1},y_{n+1},z_{n+1}$ position of said layer and on top of a volume element in a discrete $x_m,y_m,z_m \ldots x_n,y_n,z_n$, position of said adjacent layer, or

○ a discrete $x_{m+3a},y_{m+3a},z_{m+3a} \ldots x_{n+3a},y_{n+3a},z_{n+3a}$ position adjacent and on top of a volume element in a discrete $x_{m+2a},y_{m+2a},z_{m+2a} \ldots x_{n+2a},y_{n+2a},z_{n+2a}$ position of said next but one layer and on top of a volume element in a discrete $x_{m+1a},y_{m+1a},z_{m+1a} \ldots x_{n+1a},y_{n+1a},z_{n+1a}$ position of said layer and not on top of a volume element in a discrete $x_m,y_m,z_m \ldots x_n,y_n,z_n$, position of said adjacent layer, or

○ a discrete $x_{m+3b},y_{m+3b},z_{m+3b} \ldots x_{n+3b},y_{n+3b},z_{n+3b}$ position not adjacent and not on top of a volume element in a discrete $x_{m+2},y_{m+2},z_{m+2} \ldots x_{n+2},y_{n+2},z_{n+2}$ position of said next but one layer and on top of a volume element in a discrete $x_{m+1b},y_{m+1b},z_{m+1b} \ldots x_{n+1b},y_{n+1b},z_{n+1b}$ position of said layer and on top of a volume element in a discrete $x_m,y_m,z_m \ldots x_n,y_n,z_n$, position of said adjacent layer, or

○ a discrete $x_{m+3a},y_{m+3a},z_{m+3a} \ldots x_{n+3a},y_{n+3a},z_{n+3a}$ position adjacent and on top of a volume element in a discrete $x_{m+2a},y_{m+2a},z_{m+2a} \ldots x_{n+2a},y_{n+2a},z_{n+2a}$ position of said next but one layer and on top of a volume element in a discrete $x_{m+1a},y_{m+1a},z_{m+1a} \ldots x_{n+1a},y_{n+1a},z_{n+1a}$ position of said layer and on top of a volume element in a discrete $x_m,y_m,z_m \ldots x_n,y_n,z_n$, position of said adjacent layer.

Preferably, this condition considers a positioning of volume elements in said adjacent layer to a next but one layer. An overview with respect to possible positionings of volume elements in three layers underneath said adjacent layer to a next but one layer is given in table 1, summarizing the before mentioned. Preferably, for positioning a volume element in said layer and in said next but one layer one of the above-described conditions shall apply.

Preferably, as explained before, when positioning a volume in a discrete $x_{m+1a},y_{m+1a},z_{m+1a} \ldots x_{n+1a},y_{n+1a},z_{n+1a}$ position, in a discrete $x_{m+2a},y_{m+2a},z_{m+2a} \ldots X_{n+2a},y_{n+2a},Z_{n+2a}$ position, in a discrete $X_{m+2b},y_{m+2b},Z_{m+2b} \ldots X_{n+2b},y_{n+2b},Z_{n+2b}$ position, in a discrete $X_{m+3a},y_{m+3a},Z_{m+3a} \ldots X_{n+3a},y_{n+3a},Z_{n+3a}$ position, or in a discrete $x_{m+3b},y_{m+3b},z_{m+3b} \ldots x_{n+3b},y_{n+3b},z_{n+3b}$ position in each of said layers a maximum distance between two volume elements is considered. Preferably, as explained before, in each of the before mentioned layers a variation in a distance between two adjacent volume elements is minimized.

Table 1: Possible positionings of volume elements in layer stack underneath adjacent layer to next but one layer

| next but one layer | $x_{m+2},y_{m+2},z_{m+2} \ldots x_{n+2},y_{n+2},z_{n+2}$ | - | - | - | + | + | + | - | + |
|---|---|---|---|---|---|---|---|---|---|
| layer | $x_{m+1},y_{m+1},z_{m+1} \ldots x_{n+1},y_{n+1},z_{n+1}$ | - | - | + | - | - | + | + | + |
| adjacent layer | $x_m,y_m,z_m \ldots x_n,y_n,z_n$ | - | + | - | - | + | - | + | + |
| - = no volume positioned, + = volume element positioned | | | | | | | | | |

Preferably, when in more than 66% of discrete $x_{m+3},y_{m+3},z_{m+3} \ldots x_{n+3},y_{n+3},z_{n+3}$ positions and in 75% or less than 75% of said discrete $x_{m+3}, y_{m+3}, z_{m+3} \ldots x_{n+3}, y_{n+3}, z_{n+3}$ positions of an adjacent layer to said next but one layer a volume element is to be positioned then said volume element is positioned in a discrete $x_{m+3b}, y_{m+3b}, z_{m+3b} \ldots x_{n+3b}, y_{n+3b}, z_{n+3b}$ position not adjacent and not on top of a volume element in a discrete $x_{m+2}, y_{m+2}, z_{m+2} \ldots x_{n+2}, y_{n+2}, z_{n+2}$ position of said next but one layer and not on top of a volume element in a discrete $x_{m+1}, y_{m+1}, z_{m+1} \ldots x_{n+1}, y_{n+1}, z_{n+1}$ position of said layer and not on top of a volume element in a discrete $x_m, y_m, z_m \ldots x_n, y_n, z_n$, position of said adjacent layer.

In case in more than 66% of discrete $x_{m+3}, y_{m+3}, z_{m+3} \ldots x_{n+3}, y_{n+3}, z_{n+3}$ positions and in 75% or less than 75% of said discrete $x_{m+3}, y_{m+3}, z_{m+3} \ldots x_{n+3}, y_{n+3}, z_{n+3}$ positions of an adjacent layer to said next but one layer a volume element is to be positioned and

(i) in one of said next but one layer, said layer or said adjacent layer a volume element is already positioned in a discrete $x_{m+2}, y_{m+2}, z_{m+2} \ldots x_{n+2}, y_{n+2}, z_{n+2}$ position, a discrete $x_{m+1}, y_{m+1}, z_{m+1} \ldots x_{n+1}, y_{n+1}, z_{n+1}$ position or in a discrete $x_m, y_m, z_m \ldots x_n, y_n, z_n$, position, or

(ii) in two of said next but one layer, said layer or said adjacent layer a volume element is already positioned in a discrete $x_{m+2}, y_{m+2}, z_{m+2} \ldots x_{n+2}, y_{n+2}, z_{n+2}$ position, a discrete $x_{m+1}, y_{m+1}, z_{m+1} \ldots x_{n+1}, y_{n+1}, z_{n+1}$ position or in a discrete $x_m, y_m, z_m \ldots x_n, y_n, z_n$, position, or

(iii) in each said next but one layer, said layer and said adjacent layer a volume element is already positioned in a discrete $x_{m+2}, y_{m+2}, z_{m+2} \ldots x_{n+2}, y_{n+2}, z_{n+2}$ position, a discrete $x_{m+1}, y_{m+1}, z_{m+1} \ldots x_{n+1}, y_{n+1}, z_{n+1}$ position and in a discrete $x_m, y_m, z_m \ldots x_n, y_n, z_n$, position,

preferably the respective before mentioned positioning shall apply.

In a preferred embodiment of the invention, the computer-implemented method is characterized by the following condition:

- when in more than 75% of discrete $x_{m+4}, y_{m+4}, z_{m+4} \ldots x_{n+4}, y_{n+4}, z_{n+4}$ positions and in less than 80% of said discrete $x_{m+4}, y_{m+4}, z_{m+4} \ldots x_{n+4}, y_{n+4}, z_{n+4}$ positions of a layer separated by three layers from said adjacent layer, i.e., of a layer being separated by said layer, said next but one layer, said adjacent layer to said next but one layer from said adjacent layer, a volume element is to be positioned then said volume element is positioned in

    ◦ a discrete $x_{m+4b}, y_{m+4b}, z_{m+4b} \ldots x_{n+4b}, y_{n+4b}, z_{n+4b}$ position not adjacent and not on top of a volume element in a discrete $x_{m+3}, y_{m+3}, z_{m+3} \ldots x_{n+3}, y_{n+3}, z_{n+3}$ position of said layer adjacent to said next but one layer and not on top of a volume element in a discrete $x_{m+2}, y_{m+2}, z_{m+2} \ldots x_{n+2}, y_{n+2}, z_{n+2}$ position of said next but one layer and not on top of a volume element in a discrete $x_{m+1}, y_{m+1}, z_{m+1} \ldots x_{n+1}, y_{n+1}, z_{n+1}$ position of said layer and not on top of a volume element in a discrete $x_m, y_m, z_m \ldots x_n, y_n, z_n$, position of said adjacent layer, or

    ◦ a discrete $x_{m+4b}, y_{m+4b}, z_{m+4b} \ldots x_{n+4b}, y_{n+4b}, z_{n+4b}$ position not adjacent and not on top of a volume element in a discrete $x_{m+3}, y_{m+3}, z_{m+3} \ldots x_{n+3}, y_{n+3}, z_{n+3}$ position of said layer adjacent to said next but one layer and not on top of a volume element in a discrete $x_{m+2}, y_{m+2}, z_{m+2} \ldots x_{n+2}, y_{n+2}, z_{n+2}$ position of said next but one layer and not on top of a volume element in a discrete $x_{m+1}, y_{m+1}, z_{m+1} \ldots x_{n+1}, y_{n+1}, z_{n+1}$ position of said layer and on top of a volume element in a discrete $x_m, y_m, z_m \ldots x_n, y_n, z_n$, position of said adjacent layer, or

    ◦ a discrete $x_{m+4b}, y_{m+4b}, z_{m+4b} \ldots x_{n+4b}, y_{n+4b}, z_{n+4b}$ position not adjacent and not on top of a volume element in a discrete $x_{m+3}, y_{m+3}, z_{m+3} \ldots x_{n+3}, y_{n+3}, z_{n+3}$ position of said layer adjacent to said next but one layer and not on top of a volume element in a discrete $x_{m+2}, y_{m+2}, z_{m+2} \ldots x_{n+2}, y_{n+2}, z_{n+2}$ position of said next but one layer and on top of a volume element in a discrete $x_{m+1b}, y_{m+1b}, z_{m+1b} \ldots x_{n+1b}, y_{n+1b}, z_{n+1b}$ position of said layer and not on top of a volume element in a discrete $x_m, y_m, z_m \ldots x_n, y_n, z_n$, position of said adjacent layer, or

    ◦ a discrete $x_{m+4b}, y_{m+4b}, z_{m+4b} \ldots x_{n+4b}, y_{n+4b}, z_{n+4b}$ position not adjacent and not on top of a volume element in a discrete $x_{m+3}, y_{m+3}, z_{m+3} \ldots x_{n+3}, y_{n+3}, z_{n+3}$ position of said layer adjacent to said next but one layer and on top of a volume element in a discrete $x_{m+2b}, y_{m+2b}, z_{m+2b} \ldots x_{n+2b}, y_{n+2b}, z_{n+2b}$ position of said next but one layer and not on top of a volume element in a discrete $x_{m+1}, y_{m+1}, z_{m+1} \ldots x_{n+1}, y_{n+1}, z_{n+1}$ position of said layer and not on top of a volume element in a discrete $x_m, y_m, z_m \ldots x_n, y_n, z_n$, position of said adjacent layer, or

    ◦ a discrete $x_{m+4a}, y_{m+4a}, z_{m+4a} \ldots x_{n+4a}, y_{n+4a}, z_{n+4a}$ position adjacent and on top of a volume element in a discrete $x_{m+3a}, y_{m+3a}, z_{m+3a} \ldots x_{n+3a}, y_{n+3a}, z_{n+3a}$ position of said layer adjacent to said next but one layer and not on top of a volume element in a discrete $x_{m+2}, y_{m+2}, z_{m+2} \ldots x_{n+2}, y_{n+2}, z_{n+2}$ position of said next but one layer and not on top of a volume element in a discrete $x_{m+1}, y_{m+1}, z_{m+1} \ldots x_{n+1}, y_{n+1}, z_{n+1}$ position of said layer and not on top of a volume element in a discrete $x_m, y_m, z_m \ldots x_n, y_n, z_n$, position of said adjacent layer, or

    ◦ a discrete $x_{m+4b}, y_{m+4b}, z_{m+4b} \ldots x_{n+4b}, y_{n+4b}, z_{n+4b}$ position not adjacent and not on top of a volume element in a discrete $x_{m+3}, y_{m+3}, z_{m+3} \ldots x_{n+3}, y_{n+3}, z_{n+3}$ position of said layer adjacent to said next but one layer and not on top of a volume element in a discrete $x_{m+2}, y_{m+2}, z_{m+2} \ldots x_{n+2}, y_{n+2}, z_{n+2}$ position of said next but one layer and on top of a volume element in a discrete $x_{m+1b}, y_{m+1b}, z_{m+1b} \ldots x_{n+1b}, y_{n+1b}, z_{n+1b}$ position of said layer and on top of a volume element in a discrete $x_m, y_m, z_m \ldots x_n, y_n, z_n$, position of said adjacent layer, or

○ a discrete $x_{m+4b}, y_{m+4b}, z_{m+4b} \cdots x_{n+4b}, y_{n+4b}, z_{n+4b}$ position not adjacent and not on top of a volume element in a discrete $x_{m+3}, y_{m+3}, z_{m+3} \cdots x_{n+3}, y_{n+3}, z_{n+3}$ position of said layer adjacent to said next but one layer and on top of a volume element in a discrete $x_{m+2b}, y_{m+2b}, z_{m+2b} \cdots x_{n+2b}, y_{n+2b}, z_{n+2b}$ position of said next but one layer and not on top of a volume element in a discrete $x_{m+1}, y_{m+1}, z_{m+1} \cdots x_{n+1}, y_{n+1}, z_{n+1}$ position of said layer and on top of a volume element in a discrete $x_m, y_m, z_m \cdots x_n, y_n, z_n$, position of said adjacent layer, or

○ a discrete $x_{m+4b}, y_{m+4b}, z_{m+4b} \cdots x_{n+4b}, y_{n+4b}, z_{n+4b}$ position not adjacent and not on top of a volume element in a discrete $x_{m+3}, y_{m+3}, z_{m+3} \cdots x_{n+3}, y_{n+3}, z_{n+3}$ position of said layer adjacent to said next but one layer and on top of a volume element in a discrete $x_{m+2b}, y_{m+2b}, z_{m+2b} \cdots x_{n+2b}, y_{n+2b}, z_{n+2b}$ position of said next but one layer and on top of a volume element in a discrete $x_{m+1b}, y_{m+1b}, z_{m+1b} \cdots x_{n+1b}, y_{n+1b}, z_{n+1b}$ position of said layer and not on top of a volume element in a discrete $x_m, y_m, z_m \cdots x_n, y_n, z_n$, position of said adjacent layer, or

○ a discrete $x_{m+4a}, y_{m+4a}, z_{m+4a} \cdots x_{n+4a}, y_{n+4a}, z_{n+4a}$ position adjacent and on top of a volume element in a discrete $x_{m+3a}, y_{m+3a}, z_{m+3a} \cdots x_{n+3a}, y_{n+3a}, z_{n+3a}$ position of said layer adjacent to said next but one layer and not on top of a volume element in a discrete $x_{m+2}, y_{m+2}, z_{m+2} \cdots x_{n+2}, y_{n+2}, z_{n+2}$ position of said next but one layer and on top of a volume element in a discrete $x_{m+1a}, y_{m+1a}, z_{m+1a} \cdots x_{n+1a}, y_{n+1a}, z_{n+1a}$ position of said layer and not on top of a volume element in a discrete $x_m, y_m, z_m \cdots x_n, y_n, z_n$, position of said adjacent layer, or

○ a discrete $x_{m+4a}, y_{m+4a}, z_{m+4a} \cdots x_{n+4a}, y_{n+4a}, z_{n+4a}$ position adjacent and on top of a volume element in a discrete $x_{m+3a}, y_{m+3a}, z_{m+3a} \cdots x_{n+3a}, y_{n+3a}, z_{n+3a}$ position of said layer adjacent to said next but one layer and on top of a volume element in a discrete $x_{m+2a}, y_{m+2a}, z_{m+2a} \cdots x_{n+2a}, y_{n+2a}, z_{n+2a}$ position of said next but one layer and not on top of a volume element in a discrete $x_{m+1}, y_{m+1}, z_{m+1} \cdots x_{n+1}, y_{n+1}, z_{n+1}$ position of said layer and not on top of a volume element in a discrete $x_m, y_m, z_m \cdots x_n, y_n, z_n$, position of said adjacent layer, or

○ a discrete $x_{m+4a}, y_{m+4a}, z_{m+4a} \cdots x_{n+4a}, y_{n+4a}, z_{n+4a}$ position adjacent and on top of a volume element in a discrete $x_{m+3a}, y_{m+3a}, z_{m+3a} \cdots x_{n+3a}, y_{n+3a}, z_{n+3a}$ position of said layer adjacent to said next but one layer and not on top of a volume element in a discrete $x_{m+2}, y_{m+2}, z_{m+2} \cdots x_{n+2}, y_{n+2}, z_{n+2}$ position of said next but one layer and on top of a volume element in a discrete $x_{m+1a}, y_{m+1a}, z_{m+1a} \cdots x_{n+1a}, y_{n+1a}, z_{n+1a}$ position of said layer and not on top of a volume element in a discrete $x_m, y_m, z_m \cdots x_n, y_n, z_n$, position of said adjacent layer, or

○ a discrete $x_{m+4b}, y_{m+4b}, z_{m+4b} \cdots x_{n+4b}, y_{n+4b}, z_{n+4b}$ position not adjacent and not on top of a volume element in a discrete $x_{m+3}, y_{m+3}, z_{m+3} \cdots x_{n+3}, y_{n+3}, z_{n+3}$ position of said layer adjacent to said next but one layer and on top of a volume element in a discrete $x_{m+2b}, y_{m+2b}, z_{m+2b} \cdots x_{n+2b}, y_{n+2b}, z_{n+2b}$ position of said next but one layer and on top of a volume element in a discrete $x_{m+1b}, y_{m+1b}, z_{m+1b} \cdots x_{n+1b}, y_{n+1b}, z_{n+1b}$ position of said layer and on top of a volume element in a discrete $x_m, y_m, z_m \cdots x_n, y_n, z_n$, position of said adjacent layer, or

○ a discrete $x_{m+4a}, y_{m+4a}, z_{m+4a} \cdots x_{n+4a}, y_{n+4a}, z_{n+4a}$ position adjacent and on top of a volume element in a discrete $x_{m+3a}, y_{m+3a}, z_{m+3a} \cdots x_{n+3a}, y_{n+3a}, z_{n+3a}$ position of said layer adjacent to said next but one layer and not on top of a volume element in a discrete $x_{m+2}, y_{m+2}, z_{m+2} \cdots x_{n+2}, y_{n+2}, z_{n+2}$ position of said next but one layer and not on top of a volume element in a discrete $x_{m+1}, y_{m+1}, z_{m+1} \cdots x_{n+1}, y_{n+1}, z_{n+1}$ position of said layer and on top of a volume element in a discrete $x_m, y_m, z_m \cdots x_n, y_n, z_n$, position of said adjacent layer, or

○ a discrete $x_{m+4a}, y_{m+4a}, z_{m+4a} \cdots x_{n+4a}, y_{n+4a}, z_{n+4a}$ position adjacent and on top of a volume element in a discrete $x_{m+3a}, y_{m+3a}, z_{m+3a} \cdots x_{n+3a}, y_{n+3a}, z_{n+3a}$ position of said layer adjacent to said next but one layer and on top of a volume element in a discrete $x_{m+2a}, y_{m+2a}, z_{m+2a} \cdots x_{n+2a}, y_{n+2a}, z_{n+2a}$ position of said next but one layer and not on top of a volume element in a discrete $x_{m+1}, y_{m+1}, z_{m+1} \cdots x_{n+1}, y_{n+1}, z_{n+1}$ position of said layer and on top of a volume element in a discrete $x_m, y_m, z_m \cdots x_n, y_n, z_n$, position of said adjacent layer, or

○ a discrete $x_{m+4a}, y_{m+4a}, z_{m+4a} \cdots x_{n+4a}, y_{n+4a}, z_{n+4a}$ position adjacent and on top of a volume element in a discrete $x_{m+3a}, y_{m+3a}, z_{m+3a} \cdots x_{n+3a}, y_{n+3a}, z_{n+3a}$ position of said layer adjacent to said next but one layer and on top of a volume element in a discrete $x_{m+2a}, y_{m+2a}, z_{m+2a} \cdots x_{n+2a}, y_{n+2a}, z_{n+2a}$ position of said next but one layer and on top of a volume element in a discrete $x_{m+1a}, y_{m+1a}, z_{m+1a} \cdots x_{n+1a}, y_{n+1a}, z_{n+1a}$ position of said layer and not on top of a volume element in a discrete $x_m, y_m, z_m \cdots x_n, y_n, z_n$, position of said adjacent layer, or

○ a discrete $x_{m+4a}, y_{m+4a}, z_{m+4a} \cdots x_{n+4a}, y_{n+4a}, z_{n+4a}$ position adjacent and on top of a volume element in a discrete $x_{m+3a}, y_{m+3a}, z_{m+3a} \cdots x_{n+3a}, y_{n+3a}, z_{n+3a}$ position of said layer adjacent to said next but one layer and on top of a volume element in a discrete $x_{m+2a}, y_{m+2a}, z_{m+2a} \cdots x_{n+2a}, y_{n+2a}, z_{n+2a}$ position of said next but one layer and on top of a volume element in a discrete $x_{m+1a}, y_{m+1a}, z_{m+1a} \cdots x_{n+1a}, y_{n+1a}, z_{n+1a}$ position of said layer and on top of a volume element in a discrete $x_m, y_m, z_m \cdots x_n, y_n, z_n$, position of said adjacent layer.

Preferably, this condition considers a positioning of volume elements in said layer a layer separated by three layers from said adjacent layer. An overview with respect to possible positionings of volume elements in four layers underneath said adjacent layer to a next but one layer is given in table 2, summarizing the before mentioned. Preferably, for positioning a volume element in said layer, in said next but one layer and in said adjacent layer to said next but one layer one of the above-described conditions shall apply.

Preferably, as explained before, when positioning a volume in a discrete $x_{m+1a}, y_{m+1a}, z_{m+1a} \cdots x_{n+1a}, y_{n+1a}, z_{n+1a}$ position, $x_{m+1b}, y_{m+1b}, z_{m+1b} \cdots x_{n+1b}, y_{n+1b}, z_{n+1b}$ position, in a discrete $x_{m+2a}, y_{m+2a}, z_{m+2a} \cdots$

Xn+2a,yn+2a,Zn+2a position, in a discrete $x_{m+2b},y_{m+2b},z_{m+2b}$ ... Xn+2b,yn+2b,Zn+2b position, in a discrete Xm+3a,ym+3a,Zm+3a ... Xn+3a,yn+3a,Zn+3a position, in a discrete Xm+3b,ym+3b,Zm+3b ... Xn+3b,yn+3b,Zn+3b position, in a discrete $x_{m+4a},y_{m+4a},z_{m+4a}$ ... Xn+4a,yn+4a,Zn+4a position or in a discrete Xm+4b,ym+4b,Zm+4b ... $x_{n+4b},y_{n+4b},z_{n+4b}$ position, in each of these layers a maximum distance between two volume elements is considered. Preferably, as explained before, in each of the before mentioned layers a variation in a distance between two adjacent volume elements is minimized.

Table 2: Possible positionings of volume elements in layer stack underneath layer separated by three layers from adjacent layer

| adjacent layer to next but one layer | $x_{m+3},y_{m+3},z_{m+3} \cdots x_{n+3},y_{n+3},z_{n+3}$ | - | - | - | - | + | - | - | - | + | + | + |
|---|---|---|---|---|---|---|---|---|---|---|---|---|
| next but one layer | $x_{m+2},y_{m+2},z_{m+2} \cdots x_{n+2},y_{n+2},z_{n+2}$ | - | - | - | + | - | - | + | + | - | + | - |
| Layer | $x_{m+1},y_{m+1},z_{m+1} \cdots x_{n+1},y_{n+1},z_{n+1}$ | - | - | + | - | - | + | - | + | + | - | + |
| adjacent layer | $x_m,y_m,z_m \cdots x_n,y_n,z_n$ | - | + | - | - | - | + | + | - | - | - | - |

- = no volume positioned, + = volume element positioned

Continuation of table 2:

| adjacent layer to next but one layer | $x_{m+3},y_{m+3},z_{m+3} \cdots x_{n+3},y_{n+3},z_{n+3}$ | - | + | + | + | + |
|---|---|---|---|---|---|---|
| next but one layer | $x_{m+2},y_{m+2},z_{m+2} \cdots x_{n+2},y_{n+2},z_{n+2}$ | + | - | + | + | + |
| Layer | $z_{m+1},y_{m+1},z_{m+1} \cdots x_{n+1},y_{n+1},z_{n+1}$ | + | + | - | + | + |
| adjacent layer | $x_m,y_m,z_m \cdots x_n,y_n,z_n$ | + | + | + | - | + |

- = no volume positioned, + = volume element positioned

Preferably, when in more than 75% of discrete $x_{m+4},y_{m+4},z_{m+4} \cdots x_{n+4},y_{n+4},z_{n+4}$ positions and in less than 80% of said discrete $x_{m+4},y_{m+4},z_{m+4} \cdots x_{n+4},y_{n+4},z_{n+4}$ positions of a layer separated by three layers from said adjacent layer, a volume element is to be positioned then said volume element is positioned in a discrete $x_{m+4b},y_{m+4b},z_{m+4b} \cdots x_{n+4b},y_{n+4b},z_{n+4b}$ position not adjacent and not on top of a volume element in a discrete $x_{m+3},y_{m+3},z_{m+3} \cdots x_{n+3},y_{n+3},z_{n+3}$ position of said layer adjacent to said next but one layer and not on top of a volume element in a discrete $x_{m+2},y_{m+2},z_{m+2} \cdots x_{n+2},y_{n+2},z_{n+2}$ position of said next but one layer and not on top of a volume element in a discrete $x_{m+1},y_{m+1},z_{m+1} \cdots x_{n+1},y_{n+1},z_{n+1}$ position of said layer and not on top of a volume element in a discrete $x_m,y_m,z_m \cdots x_n,y_n,z_n$, position of said adjacent layer.

In case, when in more than 75% of discrete $x_{m+4},y_{m+4},z_{m+4} \cdots x_{n+4},y_{n+4},z_{n+4}$ positions and in less than 80% of said discrete $x_{m+4},y_{m+4},z_{m+4} \cdots x_{n+4},y_{n+4},z_{n+4}$ positions of a layer separated by three layers from said adjacent layer a volume element is to be positioned and

(i) in one of said adjacent layer to said next but one layer, said next but one layer, said layer or said adjacent layer a volume element is already positioned in a discrete $x_{m+3},y_{m+3},z_{m+3} \cdots x_{n+3},y_{n+3},z_{n+3}$ position, in a discrete $x_{m+2},y_{m+2},z_{m+2} \cdots x_{n+2},y_{n+2},z_{n+2}$ position, in a discrete $x_{m+1},y_{m+1},z_{m+1} \cdots x_{n+1},y_{n+1},z_{n+1}$ position or in a discrete $x_m,y_m,z_m \cdots x_n,y_n,z_n$ position, or

(ii) in two of said adjacent layer to said next but one layer, said next but one layer, said layer or said adjacent layer a volume element is already positioned in a discrete $x_{m+3},y_{m+3},z_{m+3} \cdots x_{n+3},y_{n+3},z_{n+3}$ position, in a discrete $x_{m+2},y_{m+2},z_{m+2} \cdots x_{n+2},y_{n+2},z_{n+2}$ position, in a discrete $x_{m+1},y_{m+1},z_{m+1} \cdots x_{n+1},y_{n+1},z_{n+1}$ position or in a discrete $x_m,y_m,z_m \cdots x_n,y_n,z_n$ position, or

(iii) in three of said adjacent layer to said next but one layer, said next but one layer, said layer or said adjacent layer a volume element is already positioned in a discrete $x_{m+3},y_{m+3},z_{m+3} \cdots$ Xn+3,yn+3,Zn+3 position, in a discrete $x_{m+2},y_{m+2},z_{m+2} \cdots x_{n+2},y_{n+2},z_{n+2}$ position, in a discrete $x_{m+1},y_{m+1},z_{m+1} \cdots x_{n+1},y_{n+1},z_{n+1}$ position or in a discrete Xm,ym,Zm ... $x_n,y_n,z_n$ position, or

(iv) in each of said adjacent layer to said next but one layer, said next but one layer, said layer or said adjacent layer a volume element is already positioned in a discrete $x_{m+3},y_{m+3},z_{m+3} ... x_{n+3},y_{n+3},z_{n+3}$ position, in a discrete $x_{m+2},y_{m+2},z_{m+2} ... x_{n+2},y_{n+2},z_{n+2}$ position, in a discrete $x_{m+1},y_{m+1},z_{m+1} ... x_{n+1},y_{n+1},z_{n+1}$ position or in a discrete $x_m,y_m,z_m ... x_n,y_n,z_n$ position

preferably the respective before described positioning shall apply.

In a preferred embodiment of the invention, the computer-implemented method is characterized by the following additional step:

(iii) determining a deviation of an actual value of a layer thickness in a discrete $x_m,y_m,z_m ... x_n,y_n,z_n$ position of said adjacent layer from a default nominal value of said layer thickness in an identical discrete $x_m,y_m,z_m ... x_n,y_n,z_n$ position of said adjacent layer.

As described above slicing a digital twin of a spectacle lens into a layer stack determines in each discrete x,y position a layer thickness of each layer of said layer stack. Said layer thickness is preset. Said layer thickness has in each discrete x,y position a default nominal value.

As further described above each layer of said layer stack is converted in a spatial volume element pattern in which volume elements are positioned or not positioned in discrete x,y,z positions. A volume element may be represented for example as cuboid with preset edge lengths, preferably a volume element is represented as cube with a preset edge length. Preferably, when projecting said layer stack in a plane held by a x direction and a y direction and when viewing each layer of said layer stack as spatial volume element pattern for example in side view then in each discrete x,y position an actual value of a layer thickness is determined. Positioning of one volume element or more volume elements in a discrete x,y position of a layer results, when viewing said layer in side view, in an actual value of a layer thickness in said discrete x,y position that is

- larger than a default nominal value of a layer thickness in an identical discrete x,y, position of said layer, or
- smaller than a default nominal value of a layer thickness in an identical discrete x,y, position of said layer, or
- equal to a default nominal value of a layer thickness in an identical discrete x,y, position of said layer.

A deviation of said actual value to said default nominal value is a difference between these two values.

In a preferred embodiment of the invention, the computer-implemented method is characterized by the following additional step:

(iv) determining a sum of said deviation and said actual value of said layer thickness.

A determination of said sum is used as valid basis for positioning or for not positioning a volume element in a discrete $x_{m+1},y_{m+1},z_{m+1} ... x_{n+1},y_{n+1},z_{n+1}$ position of said layer. Thus, said determination is used for deciding if a volume element is positioned adjacent and on top of a volume element in a discrete $x_m,y_m,z_m ... x_n,y_n,z_n$ position of said adjacent layer.

In a preferred embodiment of the invention, the computer-implemented method is further characterized by one of the following conditions:

- when said sum is larger than half said default nominal value of said layer thickness then no volume element is positioned in a discrete $x_{m+1},y_{m+1},z_{m+1} ... x_{n+1},y_{n+1},z_{n+1}$ position of said layer of said layer stack;
- when said sum is smaller than or equal to half said default nominal value of said layer thickness then a volume element is positioned in a discrete $x_{m+1},y_{m+1},z_{m+1} ... x_{n+1},y_{n+1},z_{n+1}$ position of said layer of said layer stack.

As the volume elements may be represented as cuboids with a preset edge lengths, preferably as cubes of a preset edge length and the layer thickness in each discrete x,y position of each layer is preset by slicing a digital twin of a spectacle lens into a layer stack,

(i) a positioning of one volume element or more volume elements in said discrete $x_{m+1},y_{m+1},z_{m+1} ... x_{n+1},y_{n+1},z_{n+1}$ position or

(ii) a not positioning of one volume element or more volume elements in said discrete $x_{m+1},y_{m+1},z_{m+1} ... x_{n+1},y_{n+1},z_{n+1}$ position,

each according to said condition corrects a deviation of an actual value of a layer thickness in a discrete $x_m,y_m,z_m ... x_n,y_n,z_n$ position of an adjacent layer from a default nominal value of said layer thickness in an identical discrete $x_m,y_m,z_m ... x_n,y_n,z_n$ position of said adjacent layer. Said correction of said deviation may

- correct said actual value to correspond to said default nominal value, or
- undercorrect said actual value not to correspond to said default nominal value, or
- overcorrect said actual value not to correspond to said default nominal value.

Preferably said correction of said deviation corrects said actual value to correspond to said default nominal value.

In case said correction of said deviation would result in either an undercorrection or an overcorrection of said actual value said undercorrection or said overcorrection is distributed in equal parts. Said distribution in equal parts is preferably done as, while printing a spectacle lens in layers, a total volume of ink droplets to be positioned in a layer is equivalent to a volume of said layer.

When (i) positioning one volume element or more volume elements or (ii) not positioning one volume element or more volume elements according to said condition

- a maximum distance between two adjacent volume elements in said layer, or
- a maximum distance between two adjacent stacks of volume elements in said layer, or
- a maximum distance between a volume element and an adjacent stack of volume elements in said layer

is considered. Said maximum distance preferably is a distance corresponding to a distance allowing a coalescence of ink droplets. Said ink droplets, inkjet printed a) as two adjacent ink droplets or b) as two adjacent stacks of ink droplets or c) as an ink droplet adjacent to a stack of ink droplets, preferably after coalescence form a continuous layer.

Further, when (i) positioning one volume element or more volume elements or (ii) not positioning one volume element or more volume elements according to said condition

- a variation in a distance between two adjacent volume elements in said layer, or
- a variation in a distance between two adjacent stacks of volume elements in said layer, or
- a variation in a distance between a volume element and an adjacent stack of volume elements in said layer

preferably is minimized. When inkjet printing a spectacle lens in layers considering said minimized variation in a distance

- between two adjacent ink droplets in a layer, or
- between two adjacent stacks of ink droplets in a layer, or
- between an ink droplet and an adjacent stack of ink droplets in a layer

preferably enables a smoothest possible surface of said layer.

In a preferred embodiment of the invention, the computer-implemented method is further characterized by one of the following additional steps selected from:

- determining a deviation of a default nominal value of a layer thickness in said discrete $x_{m+1}, y_{m+1}, z_{m+1} \dots x_{n+1}, y_{n+1}, z_{n+1}$ position of said layer following said positioning of a volume element and distributing said deviation to an adjacent discrete $x_{o+1}, y_{o+1}, z_{o+1} \dots x_{p+1}, y_{p+1}, z_{p+1}$ position within said identical layer;
- determining a deviation of a default nominal value of a layer thickness in said discrete $x_{m+1}, y_{m+1}, z_{m+1} \dots x_{n+1}, y_{n+1}, z_{n+1}$ position of said layer following said positioning of a volume element and transferring said deviation to a discrete $x_{m+2}, y_{m+2}, z_{m+2} \dots x_{n+2}, y_{n+2}, z_{n+2}$ position of said next but one layer;
- determining a deviation of a default nominal value of a layer thickness in said discrete $x_{m+1}, y_{m+1}, z_{m+1} \dots x_{n+1}, y_{n+1}, z_{n+1}$ position of said layer following said non-positioning of a volume element and distributing said deviation to an adjacent discrete $x_{o+1}, y_{o+1}, z_{o+1} \dots x_{p+1}, y_{p+1}, z_{p+1}$ position within said identical layer;
- determining a deviation of a default nominal value of a layer thickness in said discrete $x_{m+1}, y_{m+1}, z_{m+1} \dots x_{n+1}, y_{n+1}, z_{n+1}$ position of said layer following said non-positioning of a volume element and transferring said deviation to a discrete $x_{m+2}, y_{m+2}, z_{m+2} \dots x_{n+2}, y_{n+2}, z_{n+2}$ position of said next but one layer.

In case said layer is a final layer of said layer stack then said transferring of said deviation is only possible within said final layer.

As described before, the volume elements may be represented as cuboids with a preset edge lengths, and preferably are represented as cubes of a preset edge length and the layer thickness in each discrete x,y position of each layer is preset by slicing a digital twin of a spectacle lens into a layer stack.

Subsequently to a

(i) positioning of one volume element or more volume elements in a discrete $x_{m+1}, y_{m+1}, z_{m+1} \dots x_{n+1}, y_{n+1}, z_{n+1}$ position of said layer, or

(ii) not positioning of one volume element or more volume elements in a discrete $x_{m+1}, y_{m+1}, z_{m+1} \dots x_{n+1}, y_{n+1}, z_{n+1}$ position of said layer,

an actual value of a layer thickness in a discrete $x_{m+1}, y_{m+1}, z_{m+1} \dots x_{n+1}, y_{n+1}, z_{n+1}$ position of said layer is determined and compared to a default nominal value of said layer thickness a discrete $x_{m+1},y_{m+1},z_{m+1} \cdots x_{n+1},y_{n+1},z_{n+1}$ position of said layer. A deviation from said default nominal value is

- distributed to an adjacent discrete $x_{o+1},y_{o+1},z_{o+1} \cdots x_{p+1},y_{p+1},z_{p+1}$ position within said identical layer, and
- transferred to a discrete $x_{m+2},y_{m+2},z_{m+2} \cdots x_{n+2},y_{n+2},z_{n+2}$ position of a next but one layer.

Distributing said deviation to one adjacent discrete $x_{o+1},y_{o+1},z_{o+1} \cdots x_{p+1},y_{p+1},z_{p+1}$ position or more adjacent $x_{o1+1},y_{o1+1},z_{o1+1} \cdots x_{p1+1},y_{p1+1},z_{p1+1}$ positions shall mean that when determining an actual layer thickness in said discrete $x_{o+1},y_{o+1},z_{o+1} \cdots x_{p+1},y_{p+1},z_{p+1}$ position or in said discrete $x_{o1+1},y_{o1+1},z_{o1+1} \cdots x_{p1+1},y_{p1+1},z_{p1+1}$ positions said deviation is considered. In case said actual value of said layer thickness in said discrete $x_{m+1},y_{m+1},z_{m+1} \cdots x_{n+1},y_{n+1},z_{n+1}$ position of said layer is smaller than said default nominal value of said layer thickness in said a discrete $x_{m+1},y_{m+1},z_{m+1} \cdots x_{n+1},y_{n+1},z_{n+1}$ position then said deviation is considered for example in that in an adjacent discrete $x_{o+1},y_{o+1},z_{o+1} \cdots x_{p+1},y_{p+1},z_{p+1}$ position the difference in layer thickness is added to an actual layer thickness in said adjacent discrete $x_{o+1},y_{o+1},z_{o+1} \cdots x_{p+1},y_{p+1},z_{p+1}$ position. In case said actual value of said layer thickness in said discrete $x_{m+1},y_{m+1},z_{m+1} \cdots x_{n+1},y_{n+1},z_{n+1}$ position of said layer is larger than said default nominal value of said layer thickness in said a discrete $x_{m+1},y_{m+1},z_{m+1} \cdots x_{n+1},y_{n+1},z_{n+1}$ position then said deviation is considered for example in that in an adjacent discrete $x_{o+1},y_{o+1},z_{o+1} \cdots x_{p+1},y_{p+1},z_{p+1}$ position the difference in layer thickness is subtracted from an actual layer thickness in said adjacent discrete $x_{o+1},y_{o+1},z_{o+1} \cdots x_{p+1},y_{p+1},z_{p+1}$ position. In case said actual value of said layer thickness in said discrete $x_{m+1},y_{m+1},z_{m+1} \cdots x_{n+1},y_{n+1},z_{n+1}$ position of said layer is equal to said default nominal value of said layer thickness in said a discrete $x_{m+1},y_{m+1},z_{m+1} \cdots x_{n+1},y_{n+1},z_{n+1}$ position no transferring is needed.

Subsequently to the before described distribution of said deviation the computer-implemented method continues with and applies said step in said adjacent discrete $x_{o+1},y_{o+1},z_{o+1} \cdots x_{p+1},y_{p+1},z_{p+1}$ position, i.e., an actual value of a layer thickness in said discrete $x_{o+1},y_{o+1},z_{o+1} \cdots x_{p+1},y_{p+1},z_{p+1}$ position of said layer is determined and compared to a default nominal value of said layer thickness a discrete $x_{o+1},y_{o+1},z_{o+1} \cdots x_{p+1},y_{p+1},z_{p+1}$ position of said layer. A deviation from said default nominal value is

- distributed to an adjacent discrete $x_{q+1},y_{q+1},z_{q+1} \cdots x_{r+1},y_{r+1},z_{r+1}$ position within said identical layer, and
- transferred to a discrete $x_{m+2},y_{m+2},z_{m+2} \cdots x_{n+2},y_{n+2},z_{n+2}$ position of a next but one layer.

Said determination is continued until a deviation of an actual layer value of a thickness from a default nominal value of said layer thickness is determined for each discrete $x_{m+1},y_{m+1},z_{m+1} \cdots x_{n+1},y_{n+1},z_{n+1}$ position of said layer.

A sum of said deviation and the considered deviation distributed in a layer preferably is zero to ensure that in an inkjet printed lens a total volume of ink droplets is equivalent to a volume of a layer to be inkjet printed.

Transferring said deviation to a discrete $x_{m+2},y_{m+2},z_{m+2} \cdots x_{n+2},y_{n+2},z_{n+2}$ position of a next but one layer shall mean that said deviation is considered in said next but one layer to preferably position a volume element in said next but one layer in a discrete $x_{m+2b},y_{m+2}b,z_{m+2b} \cdots x_{n+2b},y_{n+2b},z_{n+2b}$ position not on top of a volume element in a discrete $x_{m+1},y_{m+1},z_{m+1} \cdots x_{n+1},y_{n+1},z_{n+1}$ position of said layer. Thus, said transferring contributes to achieve a smoothest possible (i) interface of a spectacle lens or (ii) surface of a spectacle when said spectacle lens is inkjet printed in layers and ink droplets are positioned according to said positioning of volume elements a discrete $x_{m+2b},y_{m+2}b,z_{m+2b} \cdots x_{n+2b},y_{n+2b},z_{n+2b}$ position.

A data processing system according to the invention comprises a processor and a storage medium coupled to the processor, wherein the processor is adapted to perform the steps:

(i) positioning a volume element in a discrete $x_{m+1},y_{m+1},z_{m+1} \cdots x_{n+1},y_{n+1},z_{n+1}$ position of a layer of a layer stack, based on a positioning of a volume element in a discrete $x_m,y_m,z_m \cdots x_n,y_n,z_n$ position of an adjacent layer of said layer stack, or
(ii) not positioning a volume element in a discrete $x_{m+1},y_{m+1},z_{m+1} \cdots x_{n+1},y_{n+1},z_{n+1}$ position of a layer of a layer stack, based on a positioning of a volume element in a discrete $x_m,y_m,z_m \cdots x_n,y_n,z_n$ position of an adjacent layer of said layer stack,

said data processing system being configured for the purpose of a use thereof for inkjet printing a spectacle lens in layers.

Said processor adapted to perform above mentioned steps may be based on a computer program stored on a storage medium. Said storage medium may be a non-transitory tangible computer-readable storage medium.

In a preferred embodiment, the data processing system comprises a processor and a storage medium coupled to the processor is adapted to perform the step according to one of the following conditions:

- when in less than 50% of said discrete $x_m,y_m,z_m \cdots x_n,y_n,z_n$ positions a volume element is positioned then no volume element is positioned in each of said discrete $x_{m+1},y_{m+1},z_{m+1} \cdots x_{n+1},y_{n+1},z_{n+1}$ positions;

- when in 50% or more than 50% of said discrete $x_m,y_m,z_m$ ... $x_n,y_n,z_n$ positions a volume element is positioned then volume elements are positioned partially in said discrete $x_{m+1},y_{m+1},z_{m+1}$ ... $x_{n+1},y_{n+1},z_{n+1}$ positions.

In a preferred embodiment, the data processing system comprises a processor and a storage medium coupled to the processor is adapted to perform a step according to one of the following conditions:

- when in less than 50% of said discrete $x_m,y_m,z_m$ ... $x_n,y_n,z_n$ positions a volume element is positioned then no volume element is positioned in each of said discrete $x_{m+1},y_{m+1},z_{m+1}$ ... $x_{n+1},y_{n+1},z_{n+1}$ positions and volume elements are positioned in each of a discrete $x_{m+2},y_{m+2},z_{m+2}$ ... $x_{n+2},y_{n+2},z_{n+2}$ positions of a next but one layer of said layer stack;
- when in 50% or more than 50% of said discrete $x_m,y_m,z_m$ ... $x_n,y_n,z_n$ positions a volume element is positioned then volume elements are positioned partially in said discrete $x_{m+1},y_{m+1},z_{m+1}$ ... $x_{n+1},y_{n+1},z_{n+1}$ positions and volume elements are positioned partially in discrete $x_{m+2},y_{m+2},z_{m+2}$ ... $x_{n+2},y_{n+2},z_{n+2}$ positions of a next but one layer of said layer stack.

In a preferred embodiment, the data processing system comprises a processor and a storage medium coupled to the processor is adapted to perform a step according to one of the following conditions:

- when in 50% or more than 50% of said discrete $x_{m+2},y_{m+2},z_{m+2}$ ... $x_{n+2},y_{n+2},z_{n+2}$ positions and in 66% or less than 66% of said discrete $x_{m+2},y_{m+2},z_{m+2}$ ... $x_{n+2},y_{n+2},z_{n+2}$ positions of said next but one layer a volume element is to be positioned then said volume element is positioned as described before with respect to a computer-implemented method;
- when in more than 66% of discrete $x_{m+3},y_{m+3},z_{m+3}$ ... $x_{n+3},y_{n+3},z_{n+3}$ positions and in 75% or less than 75% of said discrete $x_{m+3},y_{m+3},z_{m+3}$ ... $x_{n+3},y_{n+3},z_{n+3}$ positions of an adjacent layer to said next but one layer a volume element is to be positioned then said volume element is positioned as described before with respect to a computer-implemented method;
- when in more than 75% of discrete $x_{m+4},y_{m+4},z_{m+4}$ ... $x_{n+4},y_{n+4},z_{n+4}$ positions and in less than 80% of said discrete $x_{m+4},y_{m+4},z_{m+4}$ ... $x_{n+4},y_{n+4},z_{n+4}$ positions of a layer separated by three layers from said adjacent layer, i.e., of a layer being separated by said layer, said next but one layer, said adjacent layer to said next but one layer from said adjacent layer, a volume element is to be positioned then said volume element is positioned as described before with respect to a computer-implemented method.

In a preferred embodiment, the data processing system comprises a processor and a storage medium coupled to the processor is adapted to perform an additional step:
(iii) determining a deviation of an actual value of a layer thickness in a discrete $x_m,y_m,z_m$ ... $x_n,y_n,z_n$ position of said adjacent layer from a default nominal value of said layer thickness in an identical discrete $x_m,y_m,z_m$ ... $x_n,y_n,z_n$ position of said adjacent layer.
In a preferred embodiment, the data processing system comprises a processor and a storage medium coupled to the processor is adapted to perform an additional step:
(iv) determining a sum of said deviation and said actual value of said layer thickness.
In a preferred embodiment, the data processing system comprises a processor and a storage medium coupled to the processor is adapted to perform a step according to one of the following conditions:

- when said sum is larger than half said default nominal value of said layer thickness then no volume element is positioned in a discrete $x_{m+1},y_{m+1},z_{m+1}$ ... $x_{n+1},y_{n+1},z_{n+1}$ position of said layer of said layer stack;
- when said sum is smaller than or equal to half said default nominal value of said layer thickness then a volume element is positioned in a discrete $x_{m+1},y_{m+1},z_{m+1}$ ... $x_{n+1},y_{n+1},z_{n+1}$ position of said layer of said layer stack.

In a preferred embodiment, the data processing system comprises a processor and a storage medium coupled to the processor is adapted to perform one of the additional steps selected from:

- determining a deviation of a default nominal value of a layer thickness in said discrete $x_{m+1},y_{m+1},z_{m+1}$ ... $x_{n+1},y_{n+1},z_{n+1}$ position of said layer following said positioning of a volume element and distributing said deviation to an adjacent discrete $x_{o+1},y_{o+1},z_{o+1}$ ... $x_{p+1},y_{p+1},z_{p+1}$ position within said identical layer;
- determining a deviation of a default nominal value of a layer thickness in said discrete $x_{m+1},y_{m+1},z_{m+1}$ ... $x_{n+1},y_{n+1},z_{n+1}$ position of said layer following said positioning of a volume element and transferring said deviation to a discrete $x_{m+2},y_{m+2},z_{m+2}$ ... $x_{n+2},y_{n+2},z_{n+2}$ position of said next but one layer;
- determining a deviation of a default nominal value of a layer thickness in said discrete $x_{m+1},y_{m+1},z_{m+1}$ ... $x_{n+1},y_{n+1},z_{n+1}$ position of said layer following said non-positioning of a volume element and distributing said deviation to an adjacent

discrete $x_{o+1}, y_{o+1}, z_{o+1}$ ... $x_{p+1}, y_{p+1}, z_{p+1}$ position within said identical layer;

- determining a deviation of a default nominal value of a layer thickness in said discrete $x_{m+1}, y_{m+1}, z_{m+1}$ ... $x_{n+1}, y_{n+1}, z_{n+1}$ position of said layer following said non-positioning of a volume element and transferring said deviation to a discrete $x_{m+2}, y_{m+2}, z_{m+2}$ ... $x_{n+2}, y_{n+2}, z_{n+2}$ position of said next but one layer.

With respect to said data processing system the before with respect to a computer-implemented method given definitions shall apply.

In a preferred embodiment, the invention comprises a computer program, said computer program comprises instructions which, when the program is executed by a computer, cause the computer to carry out the above-described computer-implemented method.

Said computer program may be stored on a non-transitory tangible computer-readable storage medium, said computer program comprising instructions which, when said program is executed by a computer, cause the computer to carry out the above-described computer-implemented method.

In a preferred embodiment, the invention comprises a computer-readable storage medium having stored thereon said computer program. Said computer-readable storage medium may be a non-transitory tangible computer-readable storage medium.

In a preferred embodiment, the invention comprises a data signal carrying said computer program.

A data set of computer-readable printing instructions according to the invention is configured to be used for inkjet printing a spectacle lens, the data set being (i) stored on a computer-readable storage medium or (ii) transferred via a data signal. Said data set is for the purpose of a use thereof for inkjet printing a spectacle lens.

Said data set comprise printing instructions which have been generated as described before.

An inkjet printer according to the invention comprises a processor configured to cause an inkjet print head

A) to release a jet forming an ink droplet in a discrete $x_{m+1}, y_{m+1}, z_{m+1}$ ... $x_{n+1}, y_{n+1}, z_{n+1}$ position of a layer, or

B) not to release a jet forming an ink droplet in a discrete $x_{m+1}, y_{m+1}, z_{m+1}$ ... $x_{n+1}, y_{n+1}, z_{n+1}$ position of a layer

for inkjet printing a spectacle lens in layers, said release or said not release being based on an ink droplet positioning in a discrete $x_m, y_m, z_m$ ... $x_n, y_n, z_n$ position of an adjacent layer.

Said (A) release or (B) not release is completed when said spectacle lens is finished inkjet printed.

In a preferred embodiment, the inkjet printer is configured to comprise a step according to one of the following conditions:

- when in less than 50% of said discrete $x_m, y_m, z_m$ ... $x_n, y_n, z_n$ positions an ink droplet is positioned then no ink droplet is positioned in each of said discrete $x_{m+1}, y_{m+1}, z_{m+1}$ ... $x_{n+1}, y_{n+1}, z_{n+1}$ positions;
- when in 50% or more than 50% of said discrete $x_m, y_m, z_m$ ... $x_n, y_n, z_n$ positions an ink droplet is positioned then ink droplets are positioned partially in said discrete $x_{m+1}, y_{m+1}, z_{m+1}$ ... $x_{n+1}, y_{n+1}, z_{n+1}$ positions.

In a preferred embodiment, the inkjet printer is configured to comprise a step according to one of the following conditions:

- when in less than 50% of said discrete $x_m, y_m, z_m$ ... $x_n, y_n, z_n$ positions an ink droplet is positioned then no ink droplet is positioned in each of said discrete $x_{m+1}, y_{m+1}, z_{m+1}$ ... $x_{n+1}, y_{n+1}, z_{n+1}$ positions and ink droplets are positioned in each of a discrete $x_{m+2}, y_{m+2}, z_{m+2}$ ... $x_{n+2}, y_{n+2}, z_{n+2}$ positions of a next but one layer of said layer stack;
- when in 50% or more than 50% of said discrete $x_m, y_m, z_m$ ... $x_n, y_n, z_n$ positions an ink droplet is positioned then ink droplets are positioned partially in said discrete $x_{m+1}, y_{m+1}, z_{m+1}$ ... $x_{n+1}, y_{n+1}, z_{n+1}$ positions and ink droplets are positioned partially in discrete $x_{m+2}, y_{m+2}, z_{m+2}$ ... $x_{n+2}, y_{n+2}, z_{n+2}$ positions of a next but one layer of said layer stack.

In a preferred embodiment, the inkjet printer is configured to comprise a step according to one of the following conditions:

- when in 50% or more than 50% of said discrete $x_{m+2}, y_{m+2}, z_{m+2}$ ... $x_{n+2}, y_{n+2}, z_{n+2}$ positions and in 66% or less than 66% of said discrete $x_{m+2}, y_{m+2}, z_{m+2}$ ... $x_{n+2}, y_{n+2}, z_{n+2}$ positions of said next but one layer an ink droplet is to be positioned then said ink droplet is positioned as described before with respect to a computer-implemented method;
- when in more than 66% of discrete $x_{m+3}, y_{m+3}, z_{m+3}$ ... $x_{n+3}, y_{n+3}, z_{n+3}$ positions and in 75% or less than 75% of said discrete $x_{m+3}, y_{m+3}, z_{m+3}$ ... $x_{n+3}, y_{n+3}, z_{n+3}$ positions of an adjacent layer to said next but one layer an ink droplet is to be positioned then said ink droplet is positioned as described before with respect to a computer-implemented method;
- when in more than 75% of discrete $x_{m+4}, y_{m+4}, z_{m+4}$ ... $x_{n+4}, y_{n+4}, z_{n+4}$ positions and in less than 80% of said discrete

$x_{m+4},y_{m+4},z_{m+4} \dots x_{n+4},y_{n+4},z_{n+4}$ positions of a layer separated by three layers from said adjacent layer, i.e., of a layer being separated by said layer, said next but one layer, said adjacent layer to said next but one layer from said adjacent layer, an ink droplet is to be positioned then said ink droplet is positioned as described before with respect to a computer-implemented method.

In a preferred embodiment, the inkjet printer is configured to comprise an additional step:
(C) determining a deviation of an actual value of a layer thickness in a discrete $x_m,y_m,z_m \dots x_n,y_n,z_n$ position of said adjacent layer from a default nominal value of said layer thickness in an identical discrete $x_m,y_m,z_m \dots x_n,y_n,z_n$ position of said adjacent layer.

In a preferred embodiment, the inkjet printer is configured to comprise an additional step:
(D) determining a sum of said deviation and said actual value of said layer thickness.

In a preferred embodiment, the inkjet printer is configured to comprise a step according to one of the following conditions:

- when said sum is larger than half said default nominal value of said layer thickness then no ink droplet is positioned in a discrete $x_{m+1},y_{m+1},z_{m+1} \dots x_{n+1},y_{n+1},z_{n+1}$ position of said layer of said layer stack;
- when said sum is smaller than or equal to half said default nominal value of said layer thickness then an ink droplet is positioned in a discrete $x_{m+1},y_{m+1},z_{m+1} \dots x_{n+1},y_{n+1},z_{n+1}$ position of said layer of said layer stack.

In a preferred embodiment, the inkjet printer is configured to comprise one of the additional steps selected from:

- determining a deviation of a default nominal value of a layer thickness in said discrete $x_{m+1},y_{m+1},z_{m+1} \dots x_{n+1},y_{n+1},z_{n+1}$ position of said layer following said positioning of an ink droplet and distributing said deviation to an adjacent discrete $x_{o+1},y_{o+1},z_{o+1} \dots x_{p+1},y_{p+1},z_{p+1}$ position within said identical layer;
- determining a deviation of a default nominal value of a layer thickness in said discrete $x_{m+1},y_{m+1},z_{m+1} \dots x_{n+1},y_{n+1},z_{n+1}$ position of said layer following said positioning of an ink droplet and transferring said deviation to a discrete $x_{m+2},y_{m+2},z_{m+2} \dots x_{n+2},y_{n+2},z_{n+2}$ position of said next but one layer;
- determining a deviation of a default nominal value of a layer thickness in said discrete $x_{m+1},y_{m+1},z_{m+1} \dots x_{n+1},y_{n+1},z_{n+1}$ position of said layer following said non-positioning of an ink droplet and distributing said deviation to an adjacent discrete $x_{o+1},y_{o+1},z_{o+1} \dots x_{p+1},y_{p+1},z_{p+1}$ position within said identical layer;
- determining a deviation of a default nominal value of a layer thickness in said discrete $x_{m+1},y_{m+1},z_{m+1} \dots x_{n+1},y_{n+1},z_{n+1}$ position of said layer following said non-positioning of an ink droplet and transferring said deviation to a discrete $x_{m+2},y_{m+2},z_{m+2} \dots x_{n+2},y_{n+2},z_{n+2}$ position of said next but one layer.

With respect to said inkjet printer the before with respect to a computer-implemented method given definitions shall apply.

A method for inkjet printing a spectacle lens in layers according to the invention comprises one of the following steps:

a) positioning an ink droplet in a discrete $x_{m+1},y_{m+1},z_{m+1} \dots x_{n+1},y_{n+1},z_{n+1}$ position of a layer, based on a positioning of an ink droplet in an adjacent layer in a discrete $x_m,y_m,z_m \dots x_n,y_n,z_n$ position, or
b) not positioning an ink droplet in a discrete $x_{m+1},y_{m+1},z_{m+1} \dots x_{n+1},y_{n+1},z_{n+1}$ position of a layer, based on a positioning of an ink droplet in an adjacent layer in a discrete $x_m,y_m,z_m \dots x_n,y_n,z_n$ position.

According to said method said (a) positioning or (b) said not positioning is completed when said spectacle lens is finished inkjet printed.

In a preferred embodiment, the method comprises a step according to one of the following conditions:

- when in less than 50% of said discrete $x_m,y_m,z_m \dots x_n,y_n,z_n$ positions an ink droplet is positioned then no ink droplet is positioned in each of said discrete $x_{m+1},y_{m+1},z_{m+1} \dots x_{n+1},y_{n+1},z_{n+1}$ positions;
- when in 50% or more than 50% of said discrete $x_m,y_m,z_m \dots x_n,y_n,z_n$ positions an ink droplet is positioned then ink droplets are positioned partially in said discrete $x_{m+1},y_{m+1},z_{m+1} \dots x_{n+1},y_{n+1},z_{n+1}$ positions.

In a preferred embodiment, the method comprises a step according to one of the following conditions:

- when in less than 50% of said discrete $x_m,y_m,z_m \dots x_n,y_n,z_n$ positions an ink droplet is positioned then no ink droplet is positioned in each of said discrete $x_{m+1},y_{m+1},z_{m+1} \dots x_{n+1},y_{n+1},z_{n+1}$ positions and ink droplets are positioned in each of a discrete $x_{m+2},y_{m+2},z_{m+2} \dots x_{n+2},y_{n+2},z_{n+2}$ positions of a next but one layer of said layer stack;

- when in 50% or more than 50% of said discrete $x_m,y_m,z_m$ ... $x_n,y_n,z_n$ positions an ink droplet is positioned then ink droplets are positioned partially in said discrete $x_{m+1},y_{m+1},z_{m+1}$ ... $x_{n+1},y_{n+1},z_{n+1}$ positions and ink droplets are positioned partially in discrete $x_{m+2},y_{m+2},z_{m+2}$ ... $x_{n+2},y_{n+2},z_{n+2}$ positions of a next but one layer of said layer stack.

In a preferred embodiment, the method comprises a step according to one of the following conditions:

- when in 50% or more than 50% of said discrete $x_{m+2},y_{m+2},z_{m+2}$ ... $x_{n+2},y_{n+2},z_{n+2}$ positions and in 66% or less than 66% of said discrete $x_{m+2},y_{m+2},z_{m+2}$ ... $x_{n+2},y_{n+2},z_{n+2}$ positions of said next but one layer an ink droplet is to be positioned then said ink droplet is positioned as described before with respect to a computer-implemented method;
- when in more than 66% of discrete $x_{m+3},y_{m+3},z_{m+3}$ ... $x_{n+3},y_{n+3},z_{n+3}$ positions and in 75% or less than 75% of said discrete $x_{m+3},y_{m+3},z_{m+3}$ ... $x_{n+3},y_{n+3},z_{n+3}$ positions of an adjacent layer to said next but one layer an ink droplet is to be positioned then said ink droplet is positioned as described before with respect to a computer-implemented method;
- when in more than 75% of discrete $x_{m+4},y_{m+4},z_{m+4}$ ... $x_{n+4},y_{n+4},z_{n+4}$ positions and in less than 80% of said discrete $x_{m+4},y_{m+4},z_{m+4}$ ... $x_{n+4},y_{n+4},z_{n+4}$ positions of a layer separated by three layers from said adjacent layer, i.e., of a layer being separated by said layer, said next but one layer, said adjacent layer to said next but one layer from said adjacent layer, an ink droplet is to be positioned then said ink droplet is positioned as described before with respect to a computer-implemented method.

In a preferred embodiment, the method comprises an additional step:
(c) determining a deviation of an actual value of a layer thickness in a discrete $x_m,y_m,z_m$ ... $x_n,y_n,z_n$ position of said adjacent layer from a default nominal value of said layer thickness in an identical discrete $x_m,y_m,z_m$ ... $x_n,y_n,z_n$ position of said adjacent layer.

In a preferred embodiment, the method comprises an additional step:
(d) determining a sum of said deviation and said actual value of said layer thickness.

In a preferred embodiment, the method comprises a step according to one of the following conditions:

- when said sum is larger than half said default nominal value of said layer thickness then no ink droplet is positioned in a discrete $x_{m+1},y_{m+1},z_{m+1}$ ... $x_{n+1},y_{n+1},z_{n+1}$ position of said layer of said layer stack;
- when said sum is smaller than or equal to half said default nominal value of said layer thickness then an ink droplet is positioned in a discrete $x_{m+1},y_{m+1},z_{m+1}$ ... $x_{n+1},y_{n+1},z_{n+1}$ position of said layer of said layer stack.

In a preferred embodiment, the method comprises one of the additional steps selected from:

- determining a deviation of a default nominal value of a layer thickness in said discrete $x_{m+1},y_{m+1},z_{m+1}$ ... $x_{n+1},y_{n+1},z_{n+1}$ position of said layer following said positioning of an ink droplet and distributing said deviation to an adjacent discrete $x_{o+1},y_{o+1},z_{o+1}$ ... $x_{p+1},y_{p+1},z_{p+1}$ position within said identical layer;
- determining a deviation of a default nominal value of a layer thickness in said discrete $x_{m+1},y_{m+1},z_{m+1}$ ... $x_{n+1},y_{n+1},z_{n+1}$ position of said layer following said positioning of an ink droplet and transferring said deviation to a discrete $x_{m+2},y_{m+2},z_{m+2}$ ... $x_{n+2},y_{n+2},z_{n+2}$ position of said next but one layer;
- determining a deviation of a default nominal value of a layer thickness in said discrete $x_{m+1},y_{m+1},z_{m+1}$ ... $x_{n+1},y_{n+1},z_{n+1}$ position of said layer following said non-positioning of an ink droplet and distributing said deviation to an adjacent discrete $x_{o+1},y_{o+1},z_{o+1}$ ... $x_{p+1},y_{p+1},z_{p+1}$ position within said identical layer;
- determining a deviation of a default nominal value of a layer thickness in said discrete $x_{m+1},y_{m+1},z_{m+1}$ ... $x_{n+1},y_{n+1},z_{n+1}$ position of said layer following said non-positioning of an ink droplet and transferring said deviation to a discrete $x_{m+2},y_{m+2},z_{m+2}$ ... $x_{n+2},y_{n+2},z_{n+2}$ position of said next but one layer.

With respect to said method the before with respect to a computer-implemented method given definitions shall apply.

In a preferred embodiment of the invention, a spatial expansion of said layer and said adjacent layer is identical.

An identical spatial expansion means that said layer and said adjacent layer when projected in a plane held by a x direction and a y direction, in plan view, is of identical dimensions. For example, when each layer and said adjacent layer when projected in a plane held by a x direction and a y direction, in plan view, results in results in a circle, a radius of each layer resulting in said circle is identical. Being of identical dimensions does not necessarily mean that, when projected in a plane held by a x direction and a y direction, in plan view, at every point of a perimeter of said projection an ink droplet must be placed. However, said perimeter preferably is the maximal spatial expansion each layer has. Said spatial expansion may be either a spatial expansion for a spectacle lens for which

- an edging is intended, i.e., a spectacle lens corresponding to an uncut lens as defined in ISO 13666:2019(E), section 3.8.8, a finished lens prior to edging, or
- no edging is intended, i.e., a spectacle lens corresponding to an edged lens as defined in ISO 13666:2019(E), section 3.8.9, a finished lens edged to the final size and shape.

In a preferred embodiment of the invention, an outermost of said adjacent layers is inkjet printed in or on a substrate, said substrate defining a lens surface of

- a front surface of said spectacle lens or
- a back surface of said spectacle lens.

In a preferred embodiment of the invention, a total volume of ink droplets in each layer is preset.
A total volume of ink droplets being preset means that a total volume of ink is preset for each layer, i.e., said total volume is inkjet printed in a layer. No volume of said total volume is inkjet printed in another layer. Said total volume of ink droplets to be positioned in a layer is equivalent to a volume of said layer.

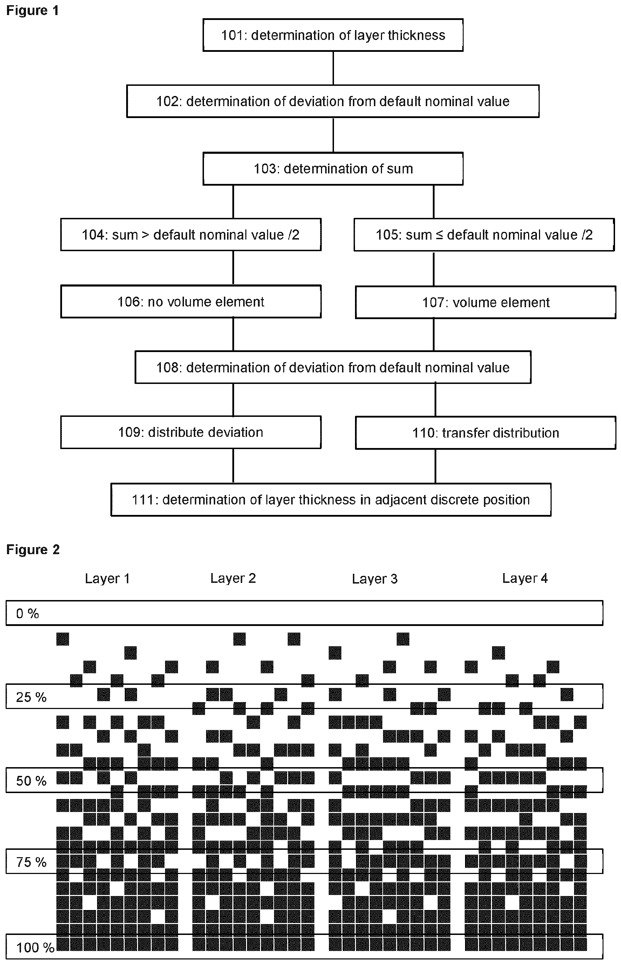

Figure 1 shows a flow chart comprising preferred embodiments of the computer-implemented method. Figure 2 shows the result of a positioning on a linear gradient structure. In the upper part, the layer thickness is zero so that no volume elements are positioned, said volume elements representing ink droplets to be inkjet printed. In the lower part, all layers are to be inkjet printed with their maximum thickness so that all ink droplets are inkjet printed and all volume elements representing them positioned. In the 50% zone, the layer is to be inkjet printed with half of the maximum thickness so here only half of the ink droplets are to be inkjet printed and only half of the volume elements representing them positioned. The positioning of the volume elements in the second layer here is complementary to the positioning of the volume elements in the first layer. The positioning of the volume elements in the fourth layer here is complementary to the positioning of the volume elements in the second layer. The positioning of the volume elements in the third layer may not be complementary to the positioning of the volume elements in the second layer. This is because at this discrete position the deviation of the layer thickness of the first layer was already equilibrated by the opposing volume element positioning of the second layer. This means the volume elements in the third layer at this discrete position are mainly positioned here minimizing the distance variation to volume elements in the same layer.
In the 25% zone, one can observe that only one volume element is positioned at each position distributed over all four layers. In the 75% zone, one can observe that three volume elements are positioned at each position distributed over all four layers.

**Claims**

1. Computer-implemented method for generating printing instructions for inkjet printing a spectacle lens, said printing instructions being based on a digital twin of said spectacle lens, said digital twin being sliced into a layer stack, the method being **characterized in** the steps:

   (i) positioning a volume element in a discrete $x_{m+1},y_{m+1},z_{m+1} \ldots x_{n+1},y_{n+1},z_{n+1}$ position of a layer of said layer stack, based on a positioning of a volume element in a discrete $x_m,y_m,z_m \ldots x_n,y_n,z_n$ position of an adjacent layer of said layer stack; or
   (ii) not positioning a volume element in a discrete $x_{m+1},y_{m+1},z_{m+1} \ldots x_{n+1},y_{n+1},z_{n+1}$ position of a layer of said layer stack, based on a positioning of a volume element in a discrete $x_m,y_m,z_m \ldots x_n,y_n,z_n$ position of an adjacent layer of said layer stack.

2. Method according to claim 1, **characterized in that** one of the following conditions apply:

   - when in less than 50% of said discrete $x_m,y_m,z_m \ldots x_n,y_n,z_n$ positions a volume element is positioned then no volume element is positioned in each of said discrete $x_{m+1},y_{m+1},z_{m+1} \ldots x_{n+1},y_{n+1},z_{n+1}$ positions;
   - when in 50% or more than 50% of said discrete $x_m,y_m,z_m \ldots x_n,y_n,z_n$ positions a volume element is positioned then volume elements are positioned partially in said discrete $x_{m+1},y_{m+1},z_{m+1} \ldots x_{n+1},y_{n+1},z_{n+1}$ positions.

3. Method according to any one of claims 1 or 2, **characterized in that** one of the following conditions apply:

   - when in less than 50% of said discrete $x_m,y_m,z_m \ldots x_n,y_n,z_n$ positions a volume element is positioned then no volume element is positioned in each of said discrete $x_{m+1},y_{m+1},z_{m+1} \ldots x_{n+1},y_{n+1},z_{n+1}$ positions and volume elements are positioned in each of a discrete $x_{m+2},y_{m+2},z_{m+2} \ldots x_{n+2},y_{n+2},z_{n+2}$ positions of a next but one layer of said layer stack;
- when in 50% or more than 50% of said discrete $x_m,y_m,z_m ... x_n,y_n,z_n$ positions a volume element is positioned then volume elements are positioned partially in said discrete $x_{m+1},y_{m+1},z_{m+1} ... x_{n+1},y_{n+1},z_{n+1}$ positions and volume elements are positioned partially in discrete $x_{m+2},y_{m+2},z_{m+2} ... x_{n+2},y_{n+2},z_{n+2}$ positions of a next but one layer of said layer stack.

4. Method according to any one of the previous claims, **characterized in** the additional step:
(iii) determining a deviation [102] of an actual value of a layer thickness in a discrete $x_m,y_m,z_m ... x_n,y_n,z_n$ position of said adjacent layer from a default nominal value [101] of said layer thickness in an identical discrete $x_m,y_m,z_m ... x_n,y_n,z_n$ position of said adjacent layer.

5. Method according to claim 4, **characterized in** the additional step:
(iv) determining a sum [103] of said deviation and said actual value of said layer thickness.

6. Method according to claim 5, **characterized in that** one of the following conditions apply:

- when said sum is larger [104] than half said default nominal value of said layer thickness then no volume element [106] is positioned in a discrete $x_{m+1},y_{m+1},z_{m+1} ... x_{n+1},y_{n+1},z_{n+1}$ position of said layer of said layer stack;
- when said sum is smaller than or equal to [105] half said default nominal value of said layer thickness then a volume element [107] is positioned in a discrete $x_{m+1},y_{m+1},z_{m+1} ... x_{n+1},y_{n+1},z_{n+1}$ position of said layer of said layer stack.

7. Method according to claim 6, **characterized in** one of the additional steps selected from:

- determining a deviation [108] of a default nominal value of a layer thickness in said discrete $x_{m+1},y_{m+1},z_{m+1} ... x_{n+1},y_{n+1},z_{n+1}$ position of said layer following said positioning of a volume element and distributing said deviation [109] to an adjacent discrete $x_{o+1},y_{o+1},z_{o+1} ... x_{p+1},y_{p+1},z_{p+1}$ position within said identical layer;
- determining a deviation [108] of a default nominal value of a layer thickness in said discrete $x_{m+1},y_{m+1},z_{m+1} ... x_{n+1},y_{n+1},z_{n+1}$ position of said layer following said positioning of a volume element and transferring said deviation [110] to a discrete $x_{m+2},y_{m+2},z_{m+2} ... x_{n+2},y_{n+2},z_{n+2}$ position of said next but one layer;
- determining a deviation [108] of a default nominal value of a layer thickness in said discrete $x_{m+1},y_{m+1},z_{m+1} ... x_{n+1},y_{n+1},z_{n+1}$ position of said layer following said non-positioning of a volume element and distributing said deviation [109] to an adjacent discrete $x_{o+1},y_{o+1},z_{o+1} ... x_{p+1},y_{p+1},z_{p+1}$ position within said identical layer;
- determining a deviation [108] of a default nominal value of a layer thickness in said discrete $x_{m+1},y_{m+1},z_{m+1} ... x_{n+1},y_{n+1},z_{n+1}$ position of said layer following said non-positioning of a volume element and transferring said deviation [110] to a discrete $x_{m+2},y_{m+2},z_{m+2} ... x_{n+2},y_{n+2},z_{n+2}$ position of said next but one layer.

8. Data processing system comprising a processor and a storage medium coupled to the processor, wherein the processor is adapted to perform the steps:

(i) positioning a volume element in a discrete $x_{m+1},y_{m+1},z_{m+1} ... x_{n+1},y_{n+1},z_{n+1}$ position of a layer of said layer stack, based on a positioning of a volume element in a discrete $x_m,y_m,z_m ... x_n,y_n,z_n$ position of an adjacent layer of said layer stack, or
(ii) not positioning a volume element in a discrete $x_{m+1},y_{m+1},z_{m+1} ... x_{n+1},y_{n+1},z_{n+1}$ position of a layer of said layer stack, based on a positioning of a volume element in a discrete $x_m,y_m,z_m ... x_n,y_n,z_n$ position of an adjacent layer of said layer stack,

said data processing system being configured for the purpose of a use thereof for inkjet printing a spectacle lens in layers.

9. Computer program comprising instructions which, when the program is executed by a computer, cause the computer to carry out the method of any one of claims 1 to 7.

10. Data set of computer-readable printing instructions configured to be used for inkjet printing a spectacle lens, the data set being (i) stored on a computer-readable storage medium or (ii) transferred via a data signal.

11. Inkjet printer comprising a processor configured to cause a print head

A) to release a jet forming an ink droplet in a discrete $x_{m+1}, y_{m+1}, z_{m+1} \ldots x_{n+1}, y_{n+1}, z_{n+1}$ position, or

B) not to release a jet forming an ink droplet in a discrete $x_{m+1}, y_{m+1}, z_{m+1} \ldots x_{n+1}, y_{n+1}, z_{n+1}$ position for inkjet printing a spectacle lens in layers, said (A) release or said (B) not release each being based on an ink droplet positioning in a discrete $x_m, y_m, z_m \ldots x_n, y_n, z_n$ position of an adjacent layer.

12. Method for inkjet printing a spectacle lens in layers, **characterized in** the steps:

   a) positioning an ink droplet in a discrete $x_{m+1}, y_{m+1}, z_{m+1} \ldots x_{n+1}, y_{n+1}, z_{n+1}$ position of a layer,

   b) not positioning an ink droplet in a discrete $x_{m+1}, y_{m+1}, z_{m+1} \ldots x_{n+1}, y_{n+1}, z_{n+1}$ position of a layer, each based on a positioning of an ink droplet in a discrete $x_m, y_m, z_m \ldots x_n, y_n, z_n$ position of an adjacent layer.

13. Method according to claim 12, **characterized in that** a spatial expansion of said layer and said adjacent layer is identical.

14. Method according to any one of previous claims 12 and 13, **characterized in that** an outermost of said adjacent layers is inkjet printed in or on a substrate, said substrate defining a lens surface of

   - a front surface of said spectacle lens or
   - a back surface of said spectacle lens.

15. Method according to any one of previous claims 12 to 14, **characterized in that** a total volume of ink droplets in a layer is preset.

**Figure 1**

```
┌─────────────────────────────────────────────────┐
│ 101: determination of layer thickness           │
└─────────────────────────────────────────────────┘
                        │
┌─────────────────────────────────────────────────┐
│ 102: determination of deviation from default    │
│      nominal value                              │
└─────────────────────────────────────────────────┘
                        │
┌─────────────────────────────────────────────────┐
│ 103: determination of sum                       │
└─────────────────────────────────────────────────┘
          │                           │
┌──────────────────────────┐ ┌──────────────────────────┐
│ 104: sum > default       │ │ 105: sum ≤ default       │
│      nominal value /2     │ │      nominal value /2     │
└──────────────────────────┘ └──────────────────────────┘
          │                           │
┌──────────────────────────┐ ┌──────────────────────────┐
│ 106: no volume element   │ │ 107: volume element      │
└──────────────────────────┘ └──────────────────────────┘
          │                           │
┌─────────────────────────────────────────────────┐
│ 108: determination of deviation from default    │
│      nominal value                              │
└─────────────────────────────────────────────────┘
          │                           │
┌──────────────────────────┐ ┌──────────────────────────┐
│ 109: distribute deviation│ │ 110: transfer distribution│
└──────────────────────────┘ └──────────────────────────┘
          │                           │
┌─────────────────────────────────────────────────┐
│ 111: determination of layer thickness in        │
│      adjacent discrete position                 │
└─────────────────────────────────────────────────┘
```

**Figure 2**

Europäisches
Patentamt

European
Patent Office

Office européen
des brevets

# EUROPEAN SEARCH REPORT

Application Number

EP 22 18 3675

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/209551 A1 (LUXEXCEL HOLDING BV [NL]) 21 October 2021 (2021-10-21) <br> * figure 1 * <br> * page 2, lines 19-23 * <br> * page 5, lines 19-25 * <br> * page 8, lines 9-25, 29-31 * <br> * page 9, lines 5-11 * <br> ----- | 1-15 | INV. <br> B29C64/112 <br> B29C64/386 <br> B29D11/00 <br> B33Y10/00 <br> B33Y50/00 |
| A | US 2021/362444 A1 (TOTZECK MICHAEL [DE] ET AL) 25 November 2021 (2021-11-25) <br> * paragraph [0131] * <br> ----- | 1-15 | |

TECHNICAL FIELDS
SEARCHED        (IPC)

B29C
B29D
B29L
B33Y

The present search report has been drawn up for all claims

| Place of search | Date of completion of the search | Examiner |
|---|---|---|
| The Hague | 19 December 2022 | Gasner, Benoit |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 18 3675

This annex lists the patent family members relating to the patent documents cited in the above-mentioned European search report.
The members are as contained in the European Patent Office EDP file on
The European Patent Office is in no way liable for these particulars which are merely given for the purpose of information.

19-12-2022

| Patent document cited in search report | | Publication date | Patent family member(s) | | | Publication date |
|---|---|---|---|---|---|---|
| WO 2021209551 | A1 | 21-10-2021 | NONE | | | |
| US 2021362444 | A1 | 25-11-2021 | CN | 113424081 | A | 21-09-2021 |
| | | | EP | 3696578 | A1 | 19-08-2020 |
| | | | EP | 3924758 | A1 | 22-12-2021 |
| | | | US | 2021362444 | A1 | 25-11-2021 |
| | | | WO | 2020165439 | A1 | 20-08-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020165439 A1